# EUROPEAN PATENT APPLICATION

(11) **EP 1 413 927 A1**
(43) Date of publication of application: **28.04.2004**
(21) Application number: 02746013.8
(22) Date of filing: 12.07.2002
(51) Int. Cl.: G03F 7/039, H01L 21/027

(54) **METHOD FOR FORMING FINE PATTERN**

(30) Priority: 12.07.2001 JP 2001212696; 14.09.2001 JP 2001280463
(71) Applicant: Semiconductor Leading Edge Technologies, Inc., Ibaraki-ken, 305-0053 (JP); Daikin Industries, Ltd., Osaka-shi, Osaka 530-8323 (JP)
(72) Inventor: TORIUMI, Minoru, c/o Yodogawa Seisakusho, Settsu-shi, Osaka 566-8585 (JP); YAMAZAKI, Tamio, Tsukuba-shi, Ibaraki 305-0053 (JP); WATANABE, Hiroyuki, Tsukuba-shi, Ibarki 305-0053 (JP); ITANI, Toshiro, Tsukuba-shi, Ibaraki 305-0053 (JP); ARAKI, Takayuki c/o Yodogawa-seisakusho, Settsu-shi, Osaka 566-8585 (JP); ISHIKAWA, Takuji c/o Yodogawa-seisakusho, Settsu-shi, Osaka 566-8585 (JP)
(74) Representative: HOFFMANN EITLE
(86) International application number: PCT/JP2002/007113
(87) International publication number: WO 2003/007080

(57) **Abstract**

There is provided a method of forming a fine resist pattern in which a highly practicable photosensitive composition obtained from a material having a high transparency against an exposure light having a short wavelength such as F₂ excimer laser beam is used as a resist. The method of forming a fine resist pattern comprises, in order, a step for forming a photosensitive layer on a substrate or on a given layer on the substrate using a photosensitive composition comprising at least a compound generating an acid by irradiation of light and a fluorine-containing polymer comprising a norbornene derivative unit having OH group or a functional group which can be converted to OH group by an acid, a step for exposing by selectively irradiating the given area of said photosensitive layer with energy ray, a step for heat-treating the exposed photosensitive layer, and a step for forming a fine pattern by developing the heat-treated photosensitive layer to selectively remove an exposed portion or an un-exposed portion of the photosensitive layer.

## Description

### TECHNICAL FIELD

The present invention relates to a method of forming a fine pattern in production of semiconductor devices.

### BACKGROUND ART

Ultra fine fabrication is required for various electronic parts such as semiconductor integrated circuit, and a resist is widely used for a processing technology therefor. With the pursuit of multi functions and high density of electronic parts, ultra fine fabrication of a resist pattern to be formed is demanded. As the resist used for fabrication of such an ultra fine pattern, there are, for example, chemically amplifying resists disclosed in JP63-27829A, etc.

The chemically amplifying resists are broadly classified into a positive type resist and a negative type resist.

The positive type chemically amplifying resist is, for example, a three-component composition comprising an alkali-soluble resin, a dissolution inhibitor and an acid generator or a two-component composition comprising an alkali-soluble resin to which a group (dissolution-inhibiting group) having a dissolution-inhibiting effect is introduced and an acid generator. When the resist is in un-exposed state, solubility thereof in an alkali developing solution is inhibited by the dissolution-inhibiting group.

When the resist film formed on a substrate is irradiated with light, X-ray, high energy electron beam or the like, an acid generator is decomposed at an exposed portion and an acid is generated and when the resist film is further subjected to heat-treating after the exposure, the acid acts as a catalyst to decompose the dissolution inhibitor. Therefore an intended pattern can be formed by dissolving and removing, with a developing solution, the exposed portion in which the dissolution inhibitor has been decomposed.

On the other hand, the negative type chemically amplifying resist is, for example, a composition comprising an acid generator, a compound having a substituent undergoing crosslinking by an acid and as case demands, an alkali-soluble resin. In the negative type resist, too, when the resist film formed on a substrate is irradiated with light, X-ray, high energy electron beam or the like, an acid is generated from the acid generator in an exposed portion like the above-mentioned positive type resist. When the resist film is subjected to heat-treating subsequently to the exposing, the acid accelerates crosslinking and therefore, solubility of the exposed portion in alkali is lowered. Therefore, by carrying out developing treatment, the thus crosslinked exposed portion remains and an un-exposed portion is dissolved and removed to form a pattern.

For forming a pattern using such a resist, a reduction projection exposure system usually called a stepper is generally used as an exposure system. As a result of a recent remarkable progress of multi functions and high density of electronic parts, a further fine circuit is demanded, which makes it necessary to form a fine pattern.

In the above-mentioned exposure system, since a pattern fabrication is carried out by projecting an optical image on a substrate, a limit of resolution depends on a wavelength of light used for the exposing. For the fine fabrication, a wavelength of light source used for the exposing has been shortened. It is a matter of certainty that in production of a device coming after a giga bit memory era, F₂ excimer laser having a wavelength of 157 nm will be mainly used as light source. Therefore, development of a chemically amplifying resist capable of forming a fine pattern using F₂ excimer laser as light source has already been initiated.

However materials which have been used for conventional resists have a large amount of absorption of F₂ excimer laser beam having a wavelength of 157 nm. When F₂ excimer laser beam is used for the exposing of a photosensitive composition prepared from such materials, sufficient amount of exposure beam does not reach the bottom of the resist. Therefore uniform exposing in the direction of a depth of the photosensitive composition formed on the substrate cannot be carried out, and it is difficult to enhance resolution.

In the recent report of study on a resist for F₂ laser prepared using a fluorine-containing polymer having a norbornene backbone (J. Photopolym. Sci. Technol., Vol. 14, No. 4 (2001) 603 - 612), there were proposed some fluorine-containing norbornene backbones having: 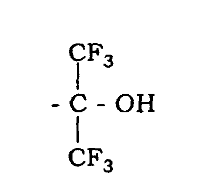 group, but there were no examples of directly bonding 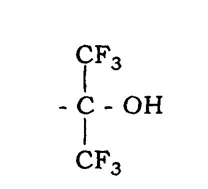 group to the norbornene backbone and introducing fluorine atom or a fluoroalkyl group to the norbornene backbone.

The present inventors have found that when introducing, directly to a norbornene backbone, a group: 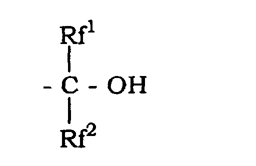 wherein Rf¹ and Rf² are the same or different and each is a fluorine-containing alkyl group having 1 to 10 carbon atoms or a fluorine-containing alkyl group which has 1 to 10 carbon atoms and ether bond, dry etching resistivity is further enhanced, and further when introducing fluorine atom to a norbornene backbone, transparency is enhanced more.

The present invention was made based on new findings to solve the mentioned problems, and an object of the present invention is to provide a method of forming a fine pattern using, as a resist, a highly practicable photosensitive composition obtained from a material having a high transparency against exposure light having a short wavelength such as F₂ excimer laser beam.

### DISCLOSURE OF INVENTION

The present invention relates to a method of forming a fine resist pattern comprising, in order, a step for forming a photosensitive layer on a substrate or a given layer on a substrate by using a photosensitive composition comprising at least a compound generating an acid by irradiation of light and a component decomposing due to the acid, a step for exposing by selectively irradiating a given area of said photosensitive layer with energy ray, a step for heat-treating the exposed photosensitive layer and a step for forming a fine pattern by developing the heat-treated photosensitive layer to selectively remove an exposed portion or an un-exposed portion of the photosensitive layer, and the component decomposing due to the acid is a fluorine-containing polymer which has a number average molecular weight of from 500 to 1,000,000 and is represented by the formula (1):

-(M1)-(M2)-(A1)- (1)

in which the structural unit M1 is a structural unit derived from an ethylenic monomer having 2 or 3 carbon atoms and at least one fluorine atom;
the structural unit M2 is a structural unit derived from at least one selected from norbornene derivatives having a fluorine-containing alcohol structure represented by the formula (2): 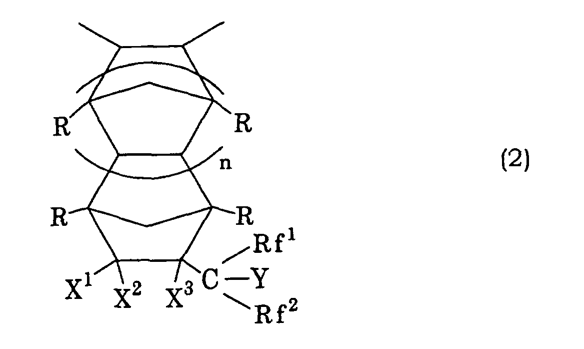 wherein Rf¹ and Rf² are the same or different and each is a fluorine-containing alkyl group having 1 to 10 carbon atoms or a fluorine-containing alkyl group which has 1 to 10 carbon atoms and ether bond; Y is OH group or a group which is dissociated due to action of an acid and converted to OH group; X¹, X² and X³ are the same or different and each is H, F, Cl, an alkyl group having 1 to 10 carbon atoms or a fluorine-containing alkyl group which has 1 to 10 carbon atoms and may have ether bond; R are the same or different and each is H or an alkyl group having 1 to 10 carbon atoms; n is 0 or an integer of from 1 to 5; at least one of X¹, X² and X³ is F or a fluorine-containing alkyl group which has 1 to 10 carbon atoms and may have ether bond;
the structural unit A1 is a structural unit derived from monomer copolymerizable with the structural units M1 and M2,
provided that M1 + M2 is 100 % by mole, a percent by mole ratio of M1/M2 is 99/1 to 30/70, and
the structural units M1, M2 and A1 are contained in amounts of from 1 to 99 % by mole, from 1 to 99 % by mole and from 0 to 98 % by mole, respectively.

In the above-mentioned fluorine-containing polymer, it is preferable that the structural unit M1 is a structural unit obtained from at least one monomer selected from the group consisting of tetrafluoroethylene and chlorotrifluoroethylene.

Also it is preferable that the structural unit M2 is a structural unit derived from the norbornene derivative having a fluorine-containing alcohol structure of the formula (2), in which X¹ and X² are H and X³ is F or CF₃, the norbornene derivative having a fluorine-containing alcohol structure of the formula (2), in which X¹ and X² are F and X³ is F or CF₃, or the norbornene derivative having a fluorine-containing alcohol structure of the formula (2), in which Rf¹ and Rf² are CF₃,

Further it is preferable that the acid-labile functional group Y is a group represented by: 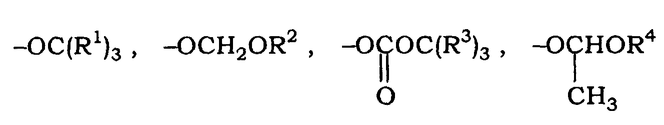 or 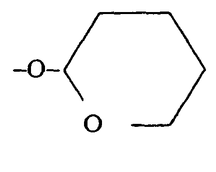 wherein R¹, R², R³ and R⁴ are the same or different and each is an alkyl group having 1 to 5 carbon atoms.

In the method of forming a fine resist pattern of the present invention, it is preferable that F₂ excimer laser beam is used as the energy ray.

In the method of forming a fine resist pattern of the present invention, it is preferable that ArF excimer laser beam is used as the energy ray.

In the method of forming a fine resist pattern of the present invention, it is preferable that KrF excimer laser beam is used as the energy ray.

In the method of forming a fine resist pattern of the present invention, it is preferable that high energy electron beam is used as the energy ray.

In the method of forming a fine resist pattern of the present invention, it is preferable that high energy ion beam is used as the energy ray.

In the method of forming a fine resist pattern of the present invention, it is preferable that X-ray is used as the energy ray.

The present invention further relates to a method of forming a fine circuit pattern comprising, in order, a step for forming a fine resist pattern on a substrate or a given layer on a substrate by any of the above-mentioned methods, and a step for forming an intended circuit pattern by etching the substrate or the given layer through the fine resist pattern.

### BRIEF DESCRIPTION OF DRAWING

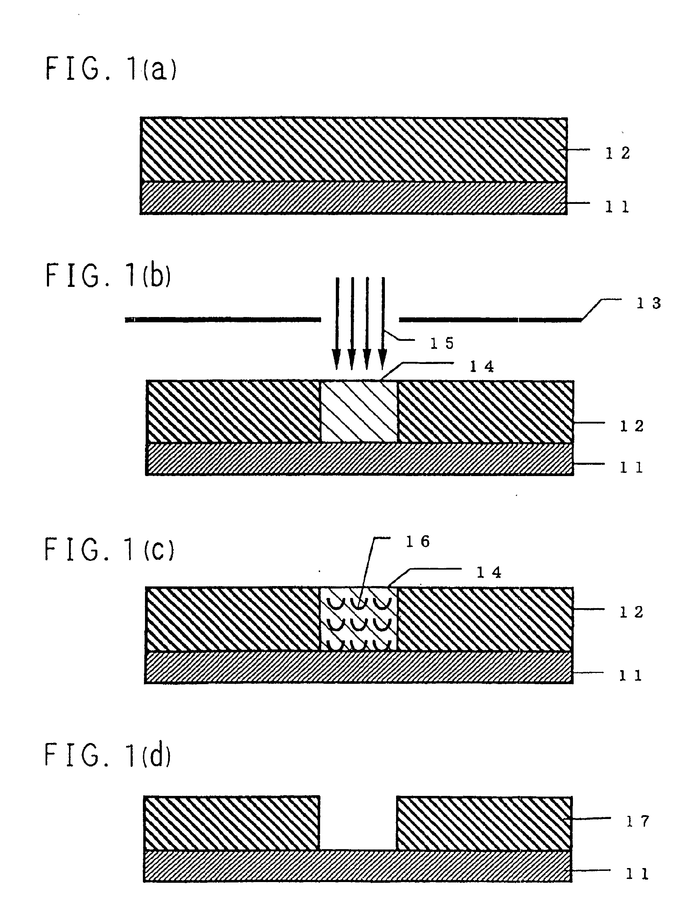

Fig. 1 is a cross-sectional view showing the steps for forming the fine pattern of the present invention.

### BEST MODE FOR CARRYING OUT THE INVENTION

The present invention is explained below in detail.

As the chemically amplifying resist directed by the present invention, there are a positive type resist and a negative type resist.

Examples of the positive type chemically amplifying resist are, for instance, a three-component composition comprising an alkali-soluble resin, dissolution inhibitor and acid generator and a two-component composition comprising an alkali-soluble resin to which a group (dissolution-inhibiting group) having a dissolution-inhibiting effect is introduced and an acid generator. In such a positive type chemically amplifying resist, when the resist is in un-exposed state, solubility thereof in an alkali developing solution is inhibited by a dissolution inhibitor (or a dissolution-inhibiting group).

The photosensitive composition in the present invention basically contains a selected material having high transparency against exposure light having a short wavelength such as F₂ excimer laser beam in order to form a precise fine pattern.

First, a high molecular weight material having high transparency of the present invention is explained below.

The photosensitive composition (photosensitive resin) used for the method of forming a fine pattern of the present invention is characterized by the use of the above-mentioned specific fluorine-containing polymer.

This fluorine-containing copolymer has, as an essential component, the structural unit M2 having the functional group Y which is OH group or the acid-labile functional group. In case of the acid-labile functional group, the acid-labile functional group in M2 is converted to OH group due to action of an acid, thereby imparting solubility in an aqueous alkaline solution (developing solution) to the polymer.

This is preferred because by selecting the structure of M2, copolymerizability becomes good, the acid-labile functional group can be introduced to the polymer in a high concentration and good solubility in an aqueous alkaline solution (developing solution) can be obtained after the acid dissociation.

In the fluorine-containing polymer of the formula (1), the structural unit M1 comprises a fluorine-containing ethylenic monomer and is preferred because an effect of enhancing good transparency, particularly transparency against ultraviolet light having a short wavelength (for example, 157 nm) can be imparted to the copolymer.

Examples of the monomer constituting the structural unit M1 are CF₂=CF₂, CF₂=CFCl, CH₂=CF₂, CFH=CH₂, CFH=CF₂, CF₂=CFCF₃, CH₂=CFCF₃, CH₂=CHCF₃ and the like.

Particularly preferred are tetrafluoroethylene (CF₂=CF₂) and chlorotrifluoroethylene (CF₂=CFCl) from the viewpoint of good copolymerizability and a high effect of imparting transparency, and further tetrafluoroethylene is preferred particularly from the viewpoint of excellent transparency.

In the fluorine-containing polymer of the formula (1), the structural unit M2 is a structural unit derived from at least one selected from the norbornene derivatives having a fluorine-containing alcohol structure represented by the formula (2): 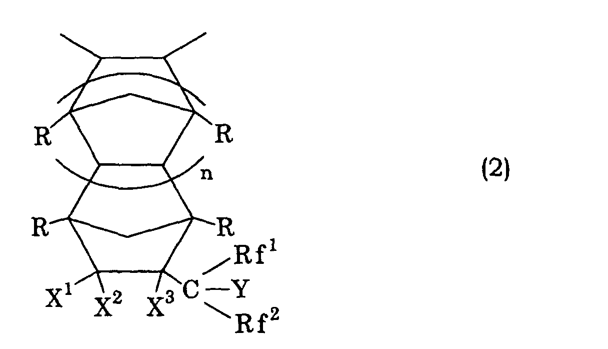 wherein Rf¹ and Rf² are the same or different and each is a fluorine-containing alkyl group having 1 to 10 carbon atoms or a fluorine-containing alkyl group which has 1 to 10 carbon atoms and ether bond; Y is OH group or a group which is dissociated due to action of an acid and converted to OH group; X¹, X² and X³ are the same or different and each is H, F, Cl, an alkyl group having 1 to 10 carbon atoms or a fluorine-containing alkyl group which has 1 to 10 carbon atoms and may have ether bond; R are the same or different and each is H or an alkyl group having 1 to 10 carbon atoms; n is 0 or an integer of from 1 to 5; at least one of X¹, X² and X³ is F or a fluorine-containing alkyl group which has 1 to 10 carbon atoms and may have ether bond;

Namely, in the present invention, the structural unit M2 derived from a norbornene derivative has a moiety: 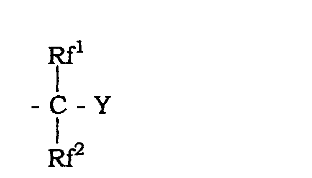 directly bonded to a norbornene backbone, and fluorine atom or a fluoroalkyl group is introduced to carbon atom, to which the above-mentioned moiety is bonded, or carbon atom adjacent thereto, thus providing both of transparency and dry etching resistivity.

In the formula (2), Rf¹ and Rf² are fluorine-containing alkyl groups having 1 to 10 carbon atoms or fluorine-containing alkyl groups having 1 to 10 carbon atoms and ether bond and may be the same or different. Also Rf¹ and Rf² are replaced with fluorine atom, and a part thereof may contain hydrogen atom and/or chlorine atom.

Examples of the Rf¹ and Rf² are, for instance, CF₃-, C₂F₅-, C₃F₇-, HCF₂CF₂-, ClF₂CF₂-, C₃F₇OCF(CF₃)CF₂-, CF₃CF₂CH₂-, CF₃CH₂- and the like. Among them, from the viewpoint of excellent transparency and enhancement of acidity of the functional group Y, preferred are perfluoroalkyl groups, and particularly preferred are CF₃-, C₂F₅- and C₃F₇-.

The functional group Y in the formula (2) is OH group or a group which is dissociated due to action of an acid and converted to OH group, and the functional group itself or OH group after the dissociation has a function of dissolving the polymer in an aqueous alkaline solution, concretely in a usual developing solution for a resist by an effect of the Rf¹ and Rf².

When the functional group Y is the group which is dissociated due to action of an acid and converted to OH group, the polymer can be used as a positive type resist. Namely, though the polymer is insoluble or less soluble in alkali before reaction with an acid, it becomes soluble in an alkaline developing solution due to action of an acid.

Examples of the acid-labile group are groups represented by: -OC(R¹)₃ , -OCH₂OR², 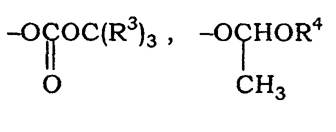 and 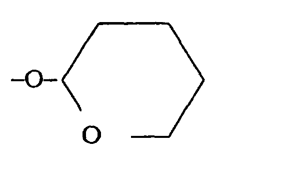 wherein R¹, R², R³ and R⁴ are the same or different and each is an alkyl group having 1 to 5 carbon atoms.

More concretely there are:

-OC(CH₃)₃, -OCH₂OCH₃, -OCH₂OC₂H₅,

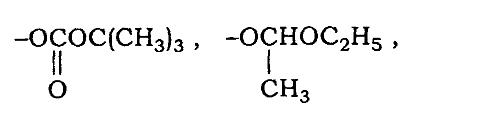

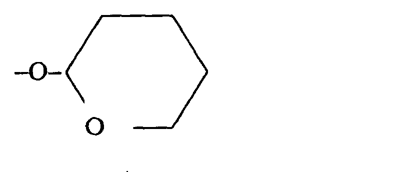

and the like. Among them, more preferable examples are -OC(CH₃)₃, 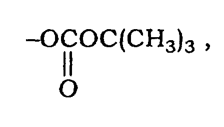 -OCH₂OCH₃ and -OCH₂OC₂H₅
from the viewpoint of good acid reactivity and further preferred are -OC(CH₃)₃, -OCH₂OCH₃ and -OCH₂OC₂H₅ from the viewpoint of good transparency.

The fluorine-containing polymer having OH group as the functional group Y can be used as a negative type resist in combination of a known crosslinking agent.

Also in the case of use of the polymer as a positive type resist, when OH group is present together with other acid-labile group, for example, a functional group converting to COOH group due to action of an acid, solubility in a developing solution and a dissolving rate can be adjusted and resolution can be enhanced.

Also the introduction of OH group is preferred since adhesion to a substrate can be improved.

In the formula (2), at least one of X¹, X² and X³ has fluorine atom or a fluorine-containing alkyl group, which can enhance transparency of the whole polymer.

The fluorine-containing alkyl group is selected from fluorine-containing alkyl groups which have 1 to 10 carbon atoms and may have ether bond. The fluorine-containing alkyl group is one in which a part or the whole of hydrogen atoms in the alkyl group are replaced with fluorine atoms, and may have chlorine atom.

Examples thereof are, for instance, -CF₃, -C₂F₅, H(CF₂)ₙ- (n is an integer of from 1 to 10), Cl(CF₂)ₙ- (n is an integer of from 1 to 10), C₃F₇OCF(CF₃)CF₂O-, CF₃CF₂CH₂CH₂-, CF₃CH₂- and the like.

Examples of the structural unit M2 of the fluorine-containing polymer to be used in the method of forming a fine patter of the present invention are: 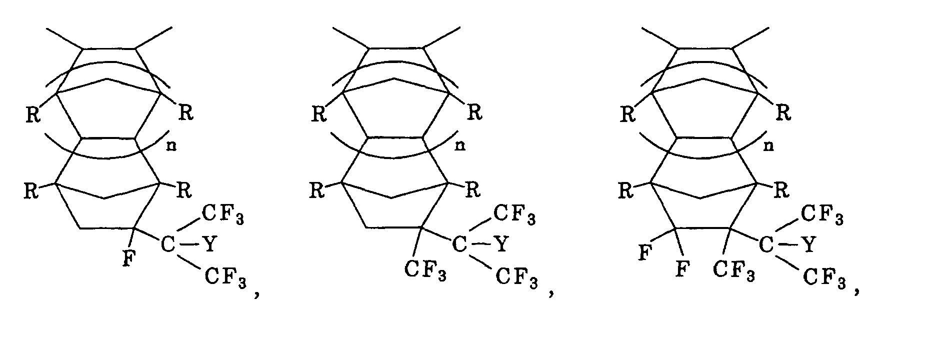 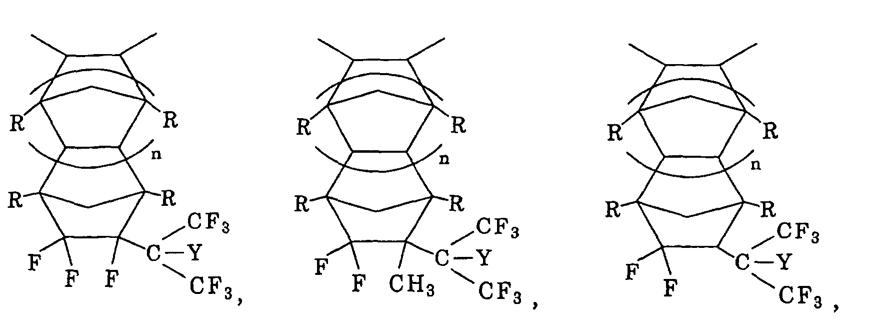 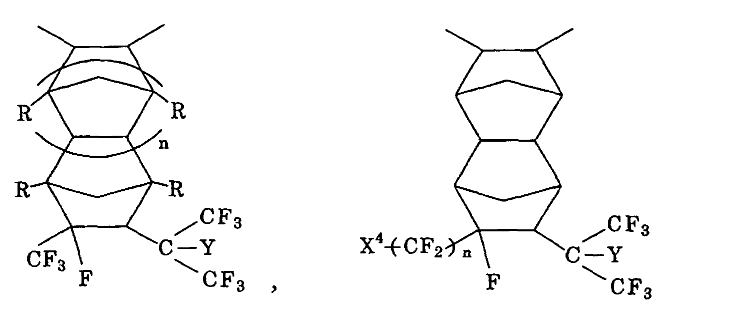 wherein X⁴ is H, F or Cl, n is from 1 to 10,
and the like, and more concretely there are: 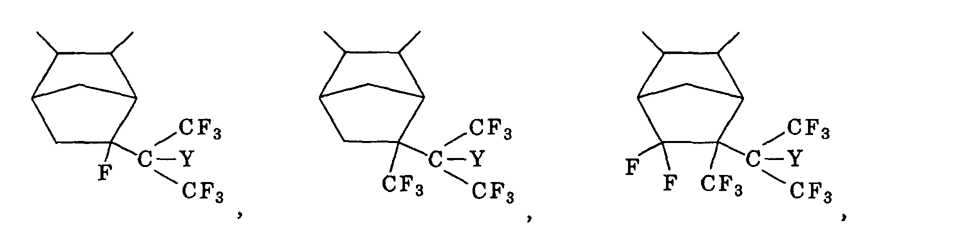 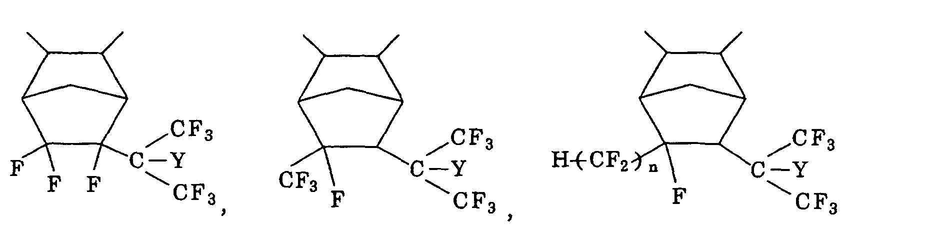 and the like.

It is important that the fluorine-containing polymer to be used in the method of forming a fine patter of the present invention has a structural unit derived from the above-mentioned specific fluorine-containing norbornene compounds having a fluorine-containing alcohol structure, which makes it possible to effectively impart, to the polymer, transparency in a vacuum ultraviolet region, dry etching resistivity and solubility in a developing solution which are necessary for a resist.

Namely, the present inventors could find that transparency was enhanced to a large extent as compared with conventional norbornene derivatives when the structure: 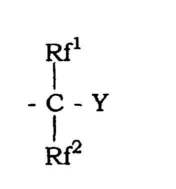 is directly bonded to the norbornene compound and further when fluorine atom or a fluorine-containing alkyl group is introduced to at least one of X¹, X² and X³ in the formula (2).

Also the present inventors have found that to their surprise, when fluorine atom or a fluorine-containing alkyl group was introduced to at least one of X¹, X² and X³, particularly when fluorine atom or a fluorine-containing alkyl group was introduced to X³, solubility in a developing solution after reaction with a photoacid generator (Y is converted to OH group), in other words, a dissolving rate in a developing solution was improved to a large extent.

Further in addition to the above-mentioned effect, dry etching resistivity also becomes good, which is preferred.

In the fluorine-containing polymer of the formula (1), A1 is a structural unit derived from monomer copolymerizable with M1 and M2. Examples thereof are, for instance, the following A2, A3, A4 and/or A5.

Examples of the structural unit A2 are those which comprise a cyclic aliphatic unsaturated hydrocarbon and are copolymerizable with the fluorine-containing ethylenic monomer constituting the M1. The introduction of A2 is preferred since dry etching resistivity as well as transparency can be enhanced.

Also the introduction of A2 is preferred since the content of M2 can be adjusted without lowering dry etching resistivity.

Also a part or the whole of hydrogen atoms of the structural unit A2 may be replaced with fluorine atoms, which is preferred because transparency can be imparted more to the polymer.

Examples of the monomer constituting the structural unit A2 are concretely: 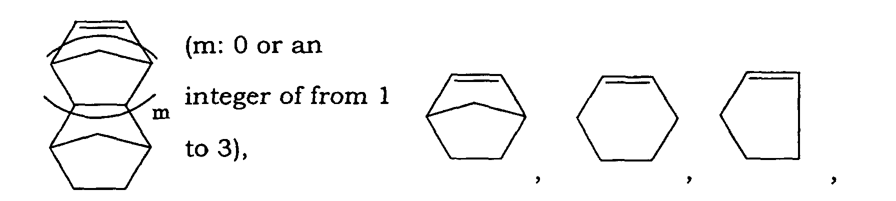 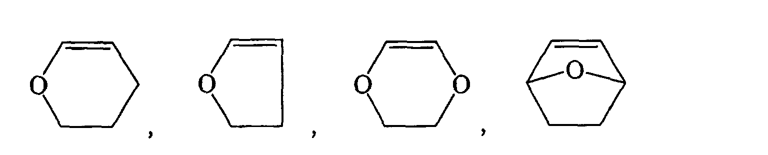 and fluorine-containing alicyclic monomers represented by the formula: 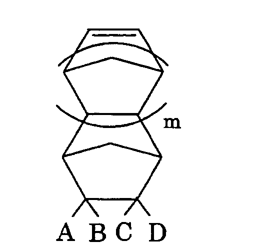 wherein A, B, C and D are H, F, an alkyl group having 1 to 10 carbon atoms or a fluorine-containing alkyl group having 1 to 10 carbon atoms; m is 0 or an integer of from 1 to 3, any one of A to D has fluorine atom.

Examples thereof are: 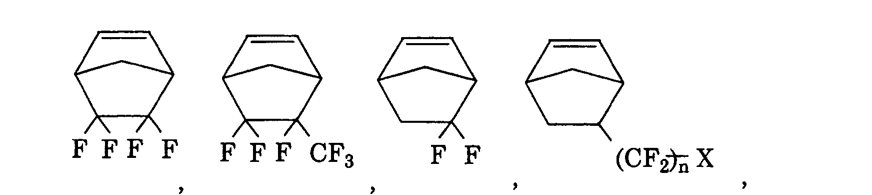 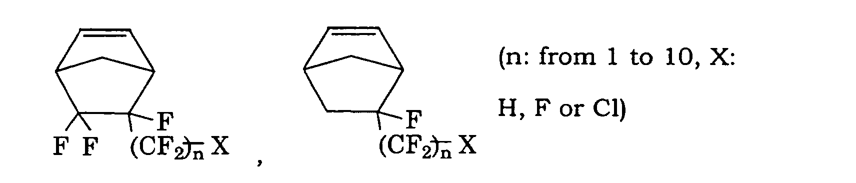 and the like.

In addition, there are: 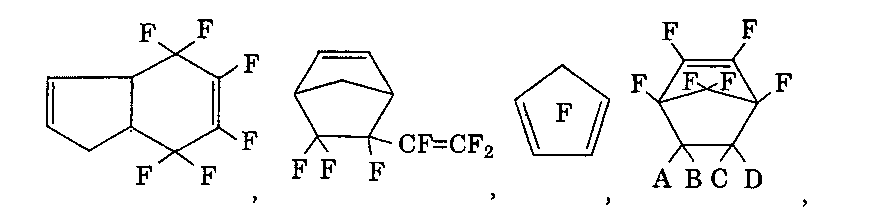 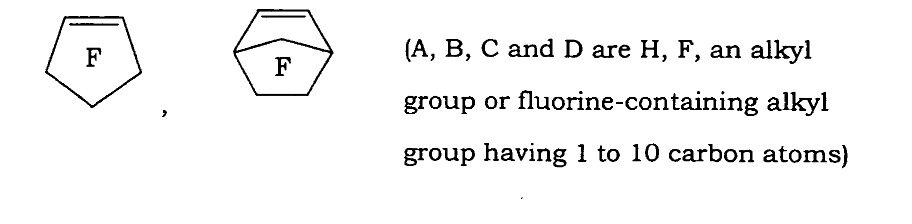 and the like.

Among them, norbornene derivatives are preferred.

The structural unit A3 comprises an ethylenic monomer having COOH group or an acid-labile functional group COOY¹ converting to carboxyl due to action of an acid and may have or may not have fluorine atom.

Example thereof is a structural unit represented by: 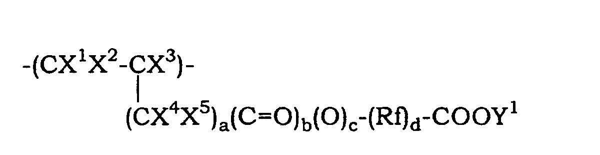 wherein COOY¹ is COOH group or an acid-labile functional group converting to carboxyl due to action of an acid; X¹ and X² are the same or different and each is H or F; X³ is H, F, Cl, CH₃ or CF₃; X⁴ and X⁵ are the same or different and each is H, F or CF₃; Rf is a fluorine-containing alkylene group having 1 to 40 carbon atoms or a fluorine-containing alkylene group having 2 to 100 carbon atoms and ether bond; a is 0 or an integer of from 1 to 3; b, c and d are the same or different and each is 0 or 1,

Examples of the structural unit A3 not containing fluorine atom (d=0) are concretely:
Acrylic monomers such as:

   CH₂=CHCOOY¹, CH₂=C(CH₃)COOY¹ and CH₂=CClCOOY¹
Maleic acid monomers such as: 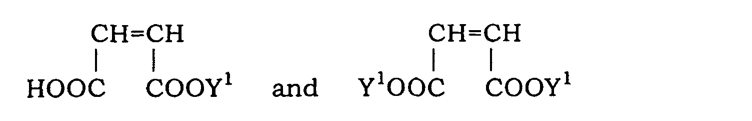
Allyl monomers such as:

   CH₂=CHCH₂COOY¹ and CH₂=CHCH₂OCH₂CH₂COOY¹,
Styrene monomers such as: 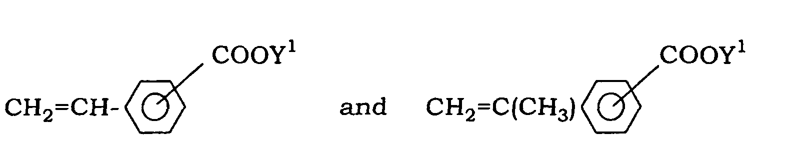 and the like.

Also examples of the structural unit A3 containing fluorine atom in its trunk chain (d=0) are:
Fluorine-containing acrylic monomers such as:

   CH₂=CFCOOY¹, CH₂=C(CF₃)COOY¹ and CF₂=CFCOOY¹
Fluorine-containing allyl monomers such as:

   CH₂=CFCF₂COOY¹, CF₂=CFCF₂COOY¹ and CH₂=CHCF₂COOY¹
Fluorine-containing styrene monomers such as: 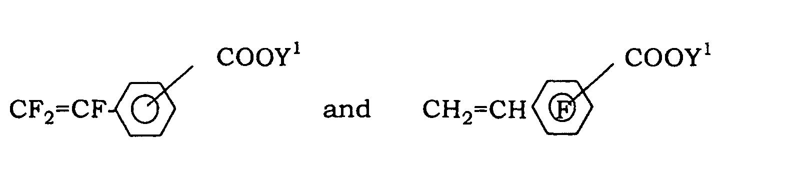 and the like.

Examples of A3 having a fluoroalkyl group in its side chain (d=1) are preferably A3-1 represented by:

CH₂=CFCF₂O-Rf-COOY¹

wherein COOY¹ and Rf are as defined in A3,
and concretely there are: 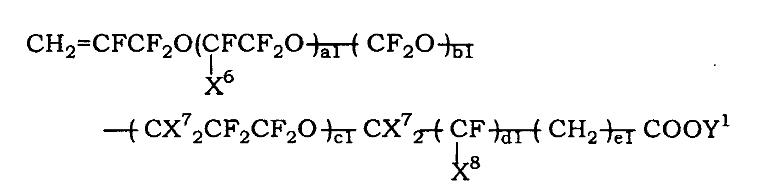 wherein a1 + b1 + c1 is from 0 to 30, d1 is 0 or 1, e1 is from 0 to 5, X⁶ is F or CF₃, X⁷ is H or F, X⁸ is H, F or CF₃,
and further concretely there are: 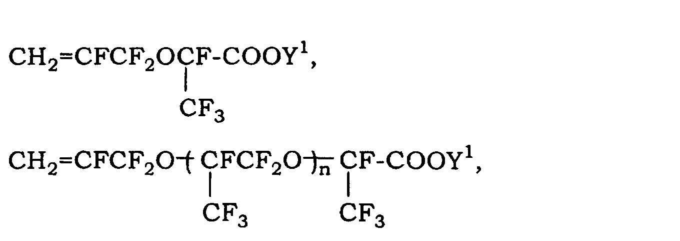 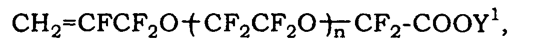 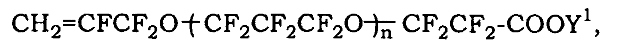 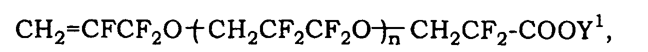 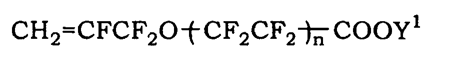 (n is an integer of from 1 to 30)
and the like.

Also preferred are A3-2 represented by:

CF₂=CFO-Rf-COOY¹

wherein COOY¹ and Rf are as defined in A3,
and concretely there are: 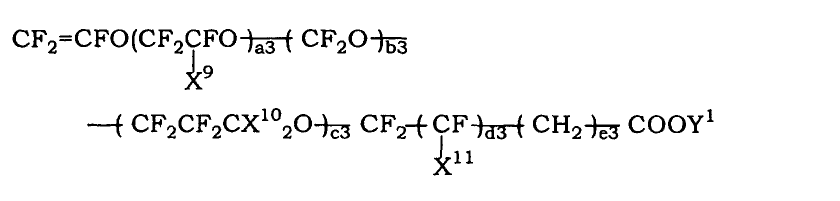 wherein a3 + b3 + c3 is from 0 to 30, d3 is 0, 1 or 2, e3 is from 0 to 5, X⁹ and X¹¹ are F or CF₃, X¹⁰ is H or F,
and further concretely there are:

CF₂=CFOCF₂CF₂-COOY¹,

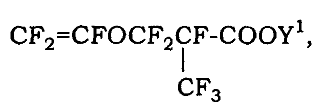

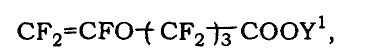

CF₂=CFOCF₂CF₂OCF₂COOY¹,

CF₂=CFOCF₂CF₂CH₂OCF₂CF₂-COOY¹

and the like.

Other examples of the monomer constituting A3 are:

CF₂=CFCF₂-O-Rf-COOY¹, CF₂=CF-Rf-COOY¹,

CH₂=CH-Rf-COOY¹, CH₂=CHO-Rf-COOY¹

(Rf is the same as Rf of the formula A3)
and the like. Further concretely there are:

CF₂=CF-CF₂OCF₂CF₂CF₂COOY¹,

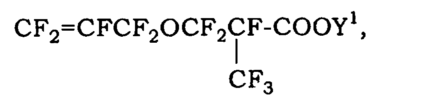

CF₂=CFCF₂-COOY¹, CH₂=CHCF₂CF₂-COOY¹,

CH₂=CHCF₂CF₂CH₂COOY¹,

CH₂=CHCF₂CF₂CF₂CF₂-COOY¹,

CH₂=CHCF₂CF₂CF₂CF₂CH₂COOY¹,

CH₂=CH₂O-CH₂CF₂CF₂-COOY¹,

CH₂=CH₂OCH₂CF₂CF₂CH₂COOY¹

and the like.

The structural unit A4 comprises a cyclic aliphatic unsaturated hydrocarbon copolymerizable with the fluorine-containing ethylenic monomer constituting M1 and further has COOH group or an acid-labile functional group COOY² which can be converted to carboxyl by an acid. The introduction of M4 is preferred because a function of being soluble in an aqueous alkali solution (developing solution) can be enhanced and also because dry etching resistivity of the whole polymer can be further enhanced.

Examples of the monomer constituting the structural unit A4 are concretely alicyclic monomers represented by: 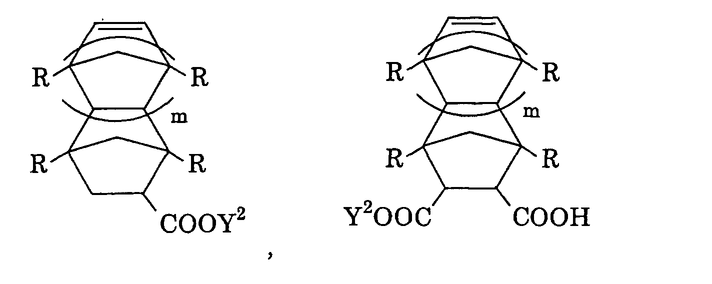 wherein R are the same or different and each is H or an alkyl group having 1 to 10 carbon atoms, m is 0 or an integer of from 1 to 3,

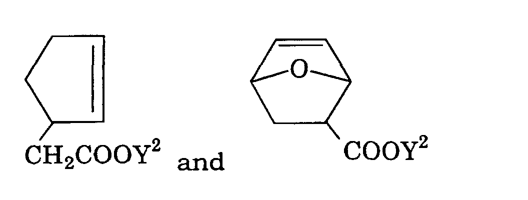

Further a part or the whole of hydrogen atoms of the structural unit A4 may be replaced with fluorine atoms, which is preferable because higher transparency can be imparted to the polymer.

Concretely there are fluorine-containing monomers represented by: 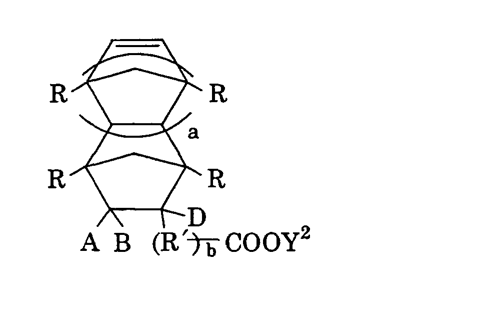 wherein A, B and D are H, F, an alkyl group having 1 to 10 carbon atoms or a fluorine-containing alkyl group having 1 to 10 carbon atoms; R are the same or different and each is H or an alkyl group having 1 to 10 carbon atoms; R' is a divalent hydrocarbon group having 1 to 20 carbon atoms, a fluorine-containing alkylene group having 1 to 20 carbon atoms or a fluorine-containing alkylene group having 2 to 100 carbon atoms and ether bond; a is 0 or an integer of from 1 to 5; b is 0 or 1; COOY² is COOH group or an acid-labile functional group which can be converted to carboxyl by an acid; when b is 0 or R' does not have fluorine atom, any one of A, B and D is fluorine atom or a fluorine-containing alkyl group.

It is preferable that any one of A, B and D is fluorine atom, and when fluorine atom is not contained in A, B and D, a fluorine content of R' is not less than 60 % and it is further preferable that R' is a perfluoroalkylene group because transparency can be imparted to the polymer.

Examples thereof are: 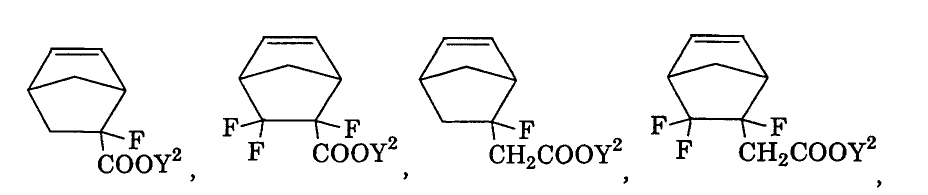 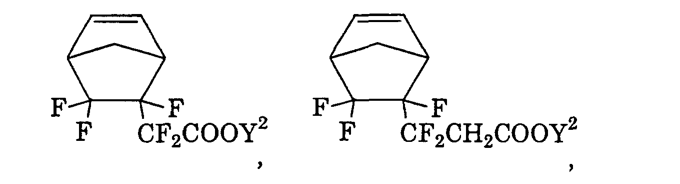 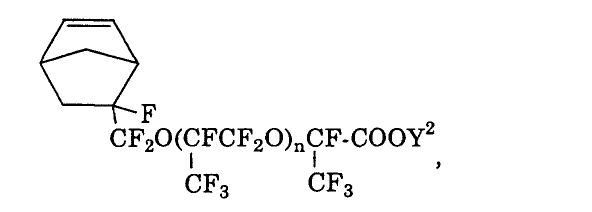 (n: from 0 to 10) 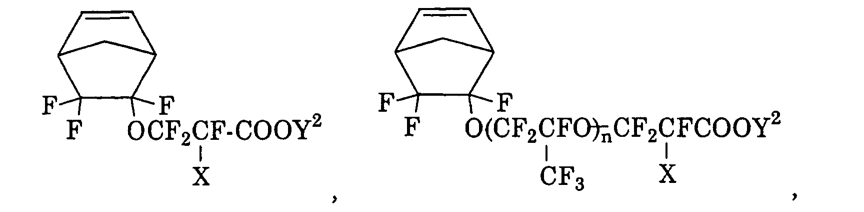 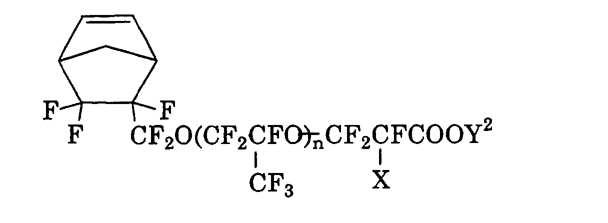 (n: 0 to 10, X: F or CF₃)
and the like.

Also there are fluorine-containing monomers represented by: 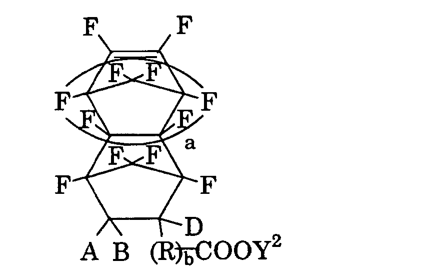 wherein A, B and D are H, F, an alkyl group having 1 to 10 carbon atoms or a fluorine-containing alkyl group having 1 to 10 carbon atoms; R is a divalent hydrocarbon group having 1 to 20 carbon atoms, a fluorine-containing alkylene group having 1 to 20 carbon atoms or a fluorine-containing alkylene group having 2 to 100 carbon atoms and ether bond; a is 0 or an integer of from 1 to 5; b is 0 or 1; COOY² is COOH group or an acid-labile functional group which can be converted to carboxyl by an acid.

Concretely there are preferably those having norbornene backbone such as: 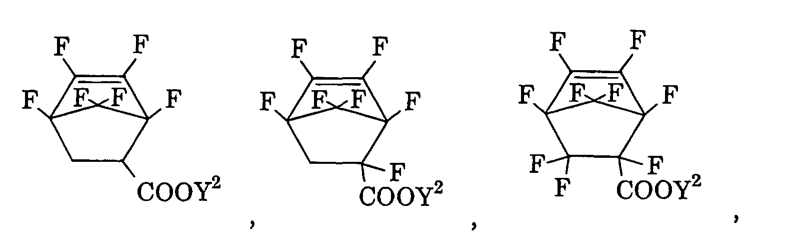 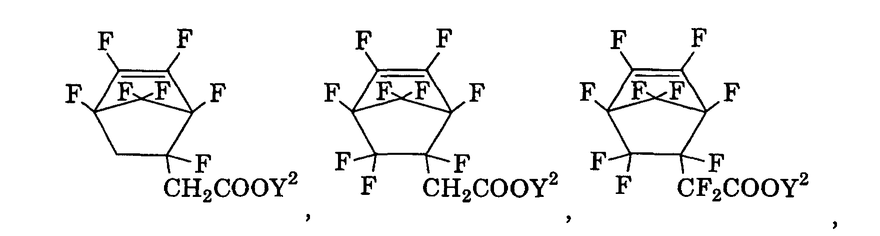 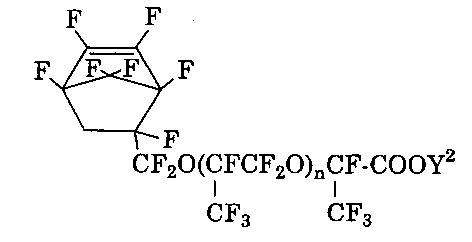 (n: from 0 to 10), 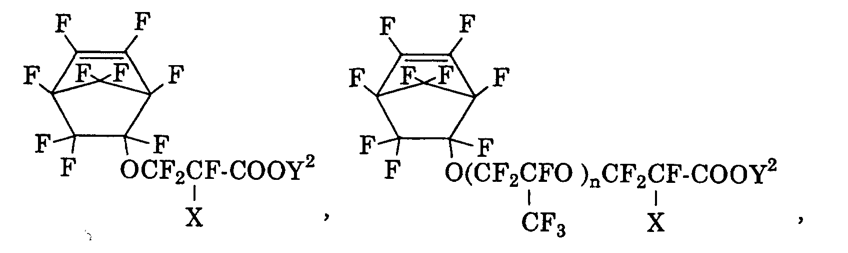 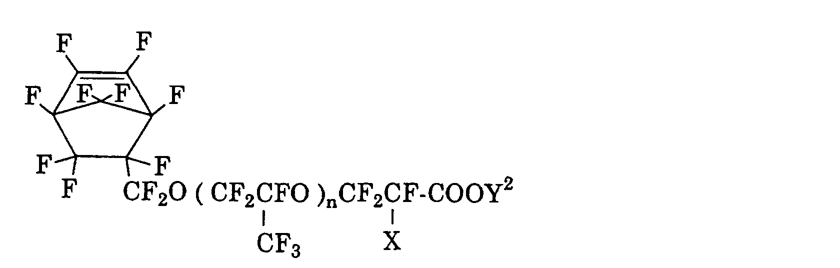 (n: from 0 to 10, X: F or CF₃)
and the like.

Other examples thereof are: 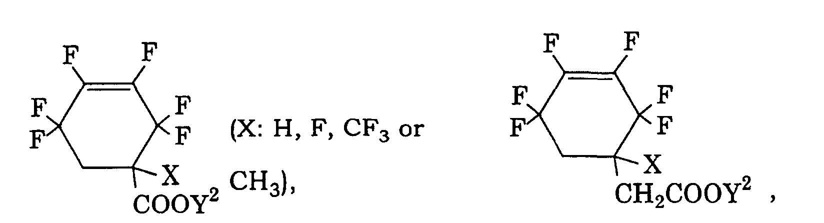 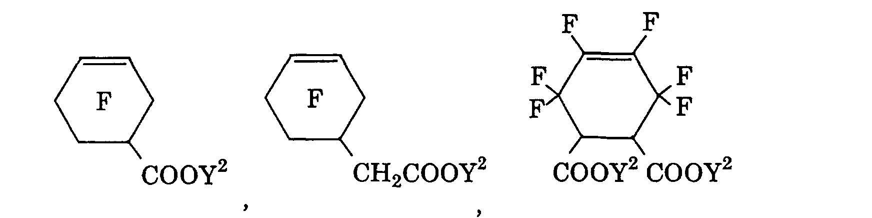 and the like.

In the structural units A3 and A4, Y¹ and Y² in the acid-labile functional groups COOY¹ and COOY² are selected from hydrocarbon groups having tertiary carbon which are capable of giving a structure in which the tertiary carbon is bonded directly to carboxyl. Examples thereof are, for instance, t-butyl group, 1,1-dimethypropyl group, adamantyl group, ethyl adamantyl group and the like. From the viewpoint of particularly good reactivity in acid dissociation, t-butyl group and -C(CH₃)₃ are preferable.

The structural unit A5 is selected from those copolymerizable with monomers constituting other structural units.

Examples thereof are, for instance:
Acrylic monomer (excluding monomers giving M1 and A3): 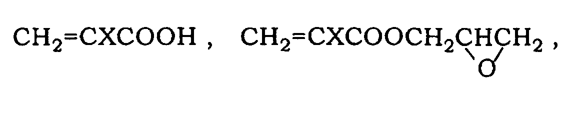 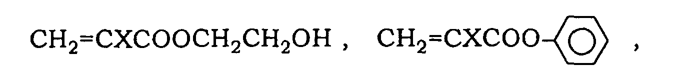 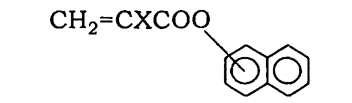 and 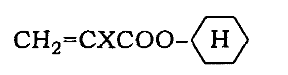
wherein X is selected from H, CH₃, F and CF₃.
Styrene monomer: 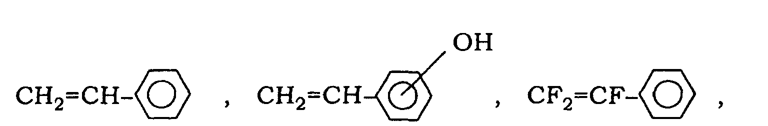 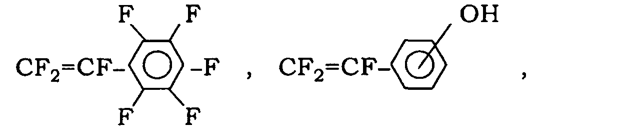 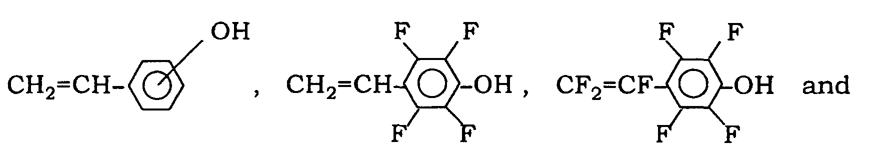 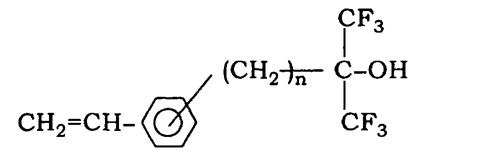 wherein n is 0 or an integer of 1 or 2.
Ethylene monomer:

CH₂=CH₂, CH₂=CHCH₃ , CH₂=CHCl

and the like.
Maleic acid monomer: 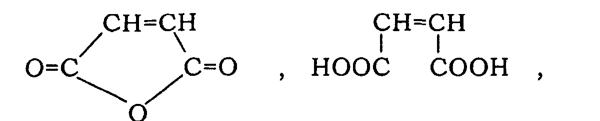 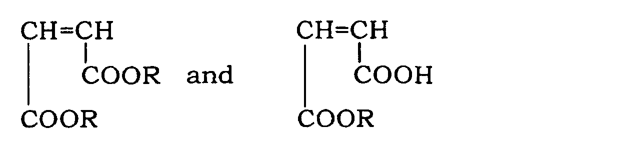 wherein R is a hydrocarbon group having 1 to 20 carbon atoms.
Allyl monomer:

CH₂=CHCH₂Cl, CH₂=CHCH₂OH, CH₂=CHCH₂COOH ,

CH₂=CHCH₂Br

and the like.
Allyl ether monomer:

CH₂=CHCH₂OR

(R is a hydrocarbon group having 1 to 20 carbon atoms), 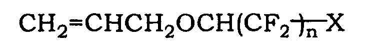 (n: from 1 to 10, X: H, Cl or F),

CH₂=CHCH₂OCH₂CH₂COOH ,

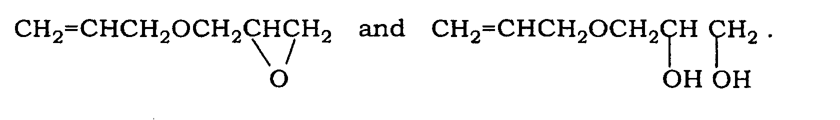

Other monomers such as: 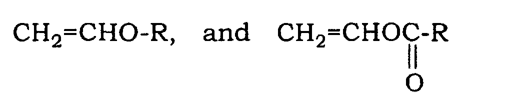 (R is an alkyl group which has 1 to 20 carbon atoms and may be replaced with fluorine atom),
and concretely there are: 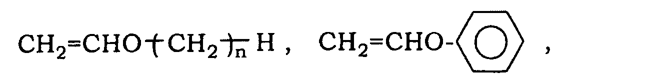 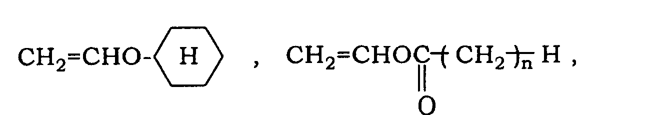 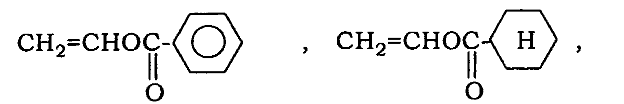 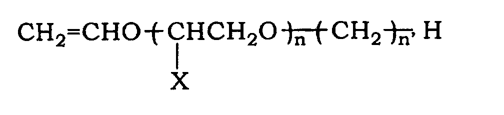 (n: 1 to 10, n': 1 to 10, X: H or CH₃) and the like.

Non-limiting examples of preferred embodiments of the fluorine-containing polymer to be used in the method of forming a fine pattern of the present invention are as follows.
(I) A fluorine-containing copolymer of - (M1) - (M2) - in which the structural unit M1 is a structural unit derived from TFE or CTFE, the structural unit M2 is a structural unit derived from the norbornene derivatives having a fluorine-containing alcohol structure of the formula (2), and the structural units M1 and M2 are contained in amounts of from 30 to 70 % by mole and from 30 to 70 % by mole, respectively.

This fluorine-containing copolymer is preferred because transparency is particularly high and dry etching resistivity is excellent.

Particularly preferred example thereof is a fluorine-containing polymer represented by the formula (1)-1:

-(M1)-(M2-1)-(M2-2)-(A1)- (1)-1

wherein the structural unit M1 is as defined in the formula (1),
the structural unit M2-1 is a structural unit derived from at least one selected from norbornene derivatives having a fluorine-containing alcohol structure represented by the formula (2)-1: 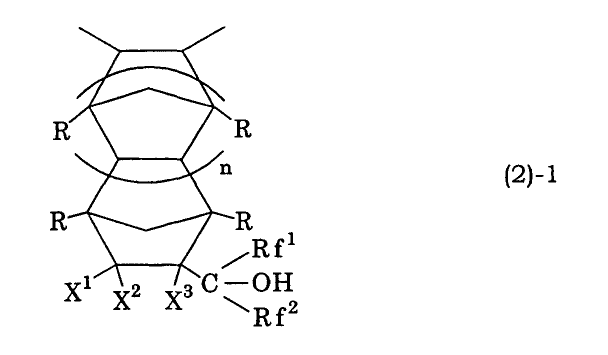 wherein Rf¹, Rf², R, X¹, X², X³ and n are as defined in the formula (2), the structural unit M2-2 is a structural unit derived from at least one selected from norbornene derivatives represented by the formula (2)-2: 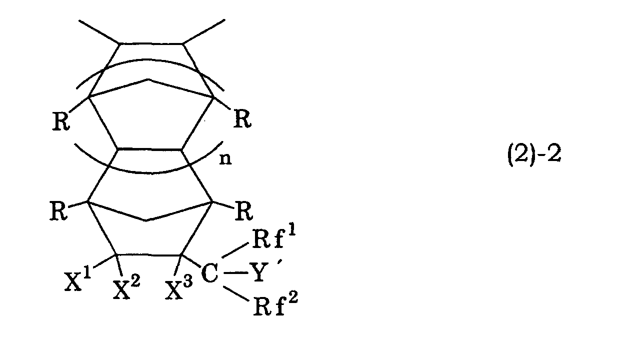 wherein Y' is a group which is dissociated due to action of an acid and converted to OH group; Rf¹, Rf², R, X¹, X², X³ and n are as defined in the formula (2),
the structural unit A1 is a structural unit derived from monomer copolymerizable with the structural units M1, M2-1 and M2-2,
provided that M1 + (M2-1) + (M2-2) is 100 % by mole, a percent by mole ratio of M1/((M2-1) + (M2-2)) is 70/30 to 30/70 and provided that (M2-1) + (M2-2) is 100 % by mole, a percent by mole ratio of (M2-1)/(M2-2) is 95/5 to 40/60, and
the structural units M1, M2-1, M2-2 and A1 are contained in amounts of from 1 to 98 % by mole, from 1 to 98 % by mole, from 1 to 98 % by mole and from 0 to 97 % by mole, respectively. This polymer is preferred since a fine resist pattern having a high resolution in F₂ lithography can be formed while maintaining transparency.

In the fluorine-containing polymer of the formula (1)-1, a percent by mole ratio of (M2-1)/(M2-2) is optionally selected in the range of 95/5 to 40/60, preferably 90/10 to 50/50, more preferably 85/ 15 to 60/40, further preferably 85/15 to 70/30. If the proportion of (M2-1) is too large, an un-exposed portion also becomes soluble and a resist pattern cannot be formed. Even if the un-exposed portion does not become soluble, a thickness of the un-exposed portion is decreased too much and the form of resist pattern becomes round and resolution is lowered. If the proportion of (M2-1) is too small, there arise problems that since adhesion to undercoating becomes insufficient, the resist is peeled at developing and a developing solution is repelled at developing, which makes it difficult to obtain uniform developing.
(II) A fluorine-containing copolymer of - (M1) - (M2) - (A2) - in which the structural unit M1 is a structural unit derived from TFE or CTFE, the structural unit M2 is a structural unit derived from the norbornene derivatives having a fluorine-containing alcohol structure of the formula (2), the structural unit A2 is a structural unit derived from monomer selected from cyclic unsaturated aliphatic hydrocarbon compounds of the structural unit A2 explained supra, and the structural units M1, M2 and A2 are contained in amounts of from 40 to 60 % by mole, from 10 to 45 % by mole and from 1 to 50 % by mole, respectively.

This fluorine-containing copolymer is preferred from the point that the amount of the functional group contained in the structural unit M2 can be adjusted without lowering dry etching resistivity. Particularly preferred A2 are those selected from the above-mentioned norbornene derivatives.
(III) A fluorine-containing copolymer of - (M1) - (M2) - (A3) - in which the structural unit M1 is a structural unit derived from TFE or CTFE, the structural unit M2 is a structural unit derived from the norbornene derivatives having a fluorine-containing alcohol structure of the formula (2), the structural unit A3 is a structural unit derived from monomer selected from ethylenic monomers of the above-mentioned structural unit A3 and among the above-mentioned structural units A3, particularly preferred is a structural unit derived from monomer selected from ethylenic monomers having an acid-labile functional group COOY¹ converting to carboxyl due to action of an acid, and the structural units M1, M2 and A3 are contained in amounts of from 10 to 60 % by mole, from 1 to 50 % by mole and from 5 to 70 % by mole, respectively.

This fluorine-containing copolymer is preferred from the point that solubility of the fluorine-containing polymer in a developing solution can be enhanced and high sensitivity and high resolution can be obtained. Particularly preferred structural unit A3 is one having fluorine atom. Concretely from the viewpoint of capability of further enhancing transparency, among the compounds explained supra, preferred are structural units derived from a fluorine-containing acrylic monomer having functional group COOY¹, a fluorine-containing allyl monomer and a fluorine-containing styrene monomer and structural units derived from monomers such as the above-mentioned A3-1 and A3-2 having a fluoroalkyl group in a side chain thereof.
(IV) A fluorine-containing copolymer of - (M1) - (M2) - (A4) - in which the structural unit M1 is a structural unit derived from TFE or CTFE, the structural unit M2 is a structural unit derived from the norbornene derivatives having a fluorine-containing alcohol structure of the formula (2), the structural unit A4 is a structural unit selected from cyclic aliphatic unsaturated hydrocarbons of the above-mentioned structural unit A4 and among the above-mentioned structural units A4, particularly preferred is a structural unit derived from monomer selected from cyclic aliphatic unsaturated hydrocarbons having an acid-labile functional group COOY² converting to carboxyl due to action of an acid, and the amount of the structural unit M1 is from 30 to 70 % by mole and the amount of the structural units M2 + A4 is from 30 to 70 % by mole.

This fluorine-containing copolymer is preferred from the point that solubility of the fluorine-containing polymer in a developing solution can be enhanced, high sensitivity and high resolution can be obtained and further dry etching resistivity can be enhanced. Particularly preferred structural unit A4 is a structural unit derived from a norbornene derivative having a functional group COOY², further preferably a norbornene derivative having fluorine atom or a fluorine-containing alkyl group. From the point that transparency can be further enhanced, preferred is, for example, a structural unit derived from the norbornene derivative represented by the formula (3): 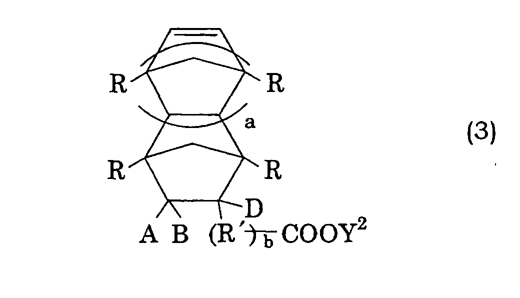 wherein A, B and D are H, F, an alkyl group having 1 to 10 carbon atoms or a fluorine-containing alkyl group having 1 to 10 carbon atoms; R are the same or different and each is H or an alkyl group having 1 to 10 carbon atoms; R' is a divalent hydrocarbon group having 1 to 20 carbon atoms, a fluorine-containing alkylene group having 1 to 20 carbon atoms or a fluorine-containing alkylene group having 2 to 100 carbon atoms and ether bond; a is 0 or an integer of from 1 to 5; b is 0 or 1; COOY² is COOH group or an acid-labile functional group which can be converted to carboxyl by an acid; when b is 0 or R' does not have fluorine atom, any one of A, B and D is fluorine atom or a fluorine-containing alkyl group.

Among them, preferred examples are fluorine-containing polymers which are represented by the formula (1)-3:

-(M1)-(M2-1)-(A4-1)-(A1)- (1)-3

wherein the structural unit M 1 and M2-1 are as defined in the formula (1)-1 of the above-mentioned polymer (II);
the structural unit A4-1 is a structural unit derived from norbornene derivatives represented by the formula (3)-1: 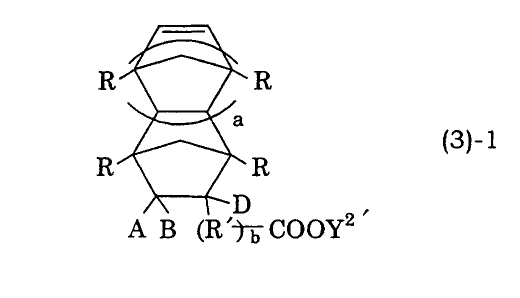 wherein COOY²' is an acid-labile functional group which can be converted to carboxyl by an acid; A, B, D, R, R', a and b are as defined in the formula (3),
the structural unit A1 is a structural unit derived from monomer copolymerizable with the structural units M1, (M2-1) and (A4-1),
provided that M1 + (M2-1) + (A4-1) is 100 % by mole, a percent by mole ratio of M1/((M2-1) + (A4-1)) is 70/30 to 30/70, and provided that (M2-1) + (A4-1) is 100 % by mole, a percent by mole ratio of (M2-1)/(A4-1) is 95/5 to 40/60, and
the structural unit M1, M2-1, A4-1 and A1 are contained in amounts of from 1 to 98 % by mole, from 1 to 98 % by mole, from 1 to 98 % by mole and from 0 to 97 % by mole, respectively.

Those polymers are preferred since a fine resist pattern having high resolution in F₂ lithography can be formed while maintaining high sensitivity.

In the fluorine-containing polymer of the formula (1)-3, a ratio of (M2-1)/(A4-1) is optionally selected in the range of 95/5 to 40/60 % by mole, preferably 90/10 to 50/50 % by mole, more preferably 85/15 to 60/40 % by mole, further preferably 85/ 15 to 70/30 % by mole. If the proportion of (M2-1) is too large, an un-exposed portion also becomes soluble and a resist pattern cannot be formed. Even if the un-exposed portion does not become soluble, a thickness of the un-exposed portion is decreased, a form of the resist pattern becomes round and resolution is lowered. If the proportion of (M2-1) is too small, there arises a problem that since adhesion to undercoating becomes insufficient, peeling occurs at developing and a developing solution is repelled at developing, which makes it difficult to obtain uniform developing. Further if the proportion of (A4-1) is too small, swelling of the un-exposed portion easily occurs, inflation of a pattern form occurs and a residue of the resist polymer (un-dissolved portion) is apt to arise at an exposed portion, which are not preferred.

In the fluorine-containing copolymer of the formula (1) of the present invention, it is necessary that the OH group-containing copolymer obtained after the dissociation reaction by an acid and the fluorine-containing copolymer having both of OH group and COOH group have sufficient solubility in a developing solution. A content of acid-labile functional group necessary therefor (a total of a functional group converting to OH group by an acid and COOH group in the case of both of the functional group and COOH group being present like the above-mentioned fluorine-containing polymer III or IV) varies depending on the components (kind of monomers), a molecular weight, etc. of the polymer. The content is preferably not less than 20 % by mole, further not less than 30 % by mole, more preferably not less than 40 % by mole based on the whole structural units constituting the fluorine-containing copolymer.

In the studies on a resist composition prepared from a fluorine-containing polymer having an acid-labile functional group and the studies on resist pattern formation by using the resist composition, the present inventors have found problems with poor adhesion of the fluorine-containing polymer to a silicon wafer substrate and occurrence of peeling of a resist at developing and cracking of a fine resist pattern.

Further there was found a problem that due to a high water repellency of a surface of a resist film, a developing solution was repelled at puddle-developing and did not extend over the resist film and thus uniform developing could not be obtained.

The present inventors have made intensive studies to solve those problems and have found that the above-mentioned two problems could be solved by dissociating a part of acid-labile functional groups in the fluorine-containing polymer of the present invention into OH groups (into either of OH groups or COOH groups in case where there are COOH group and functional groups converting to OH group by an acid). Namely, it was found that when the fluorine-containing copolymer in which even a part of functional groups was dissociated (or partly deprotected) is used, adhesion to a substrate is improved, repelling of a developing solution is improved and uniform developing can be obtained.

Also in studying various ratios of OH group being present with the acid-labile functional group, the present inventors have found that when the ratio of OH group was gradually increased, resolution could be enhanced, a form of resist pattern could be improved and a residue of polymer at an exposed portion could be reduced. As a result, a range of preferred component amounts mentioned in the above-mentioned examples of the fluorine-containing polymer (polymers of the formula (1)-1, (1)-2 and (1)-3) was found.

In the fluorine-containing copolymer of the present invention, when aiming at imparting adhesion to a substrate and reducing repelling of a developing solution, a proportion of OH groups being present by dissociation (deprotection) of an acid-labile functional group varies depending on kind, components, etc. of the copolymer, and the proportion of OH groups after the dissociation is preferably in a range of not less than 2 % by mole and less than 60 % by mole, more preferably from 5 to 50 % by mole, further preferably from 20 to 45 % by mole based on the whole structural units constituting the fluorine-containing copolymer. If the content of OH group is too high, un-exposed portions also become soluble at developing and a resist pattern cannot be formed.

Also in the fluorine-containing copolymer of the present invention, a proportion of COOH groups being present by dissociation (deprotection) of an acid-labile functional group varies depending on kind, components, etc. of the copolymer, and the proportion of COOH groups after the dissociation is preferably within a range of not less than 1 % by mole and less than 15 % by mole, more preferably from 1 to 10 % by mole, further preferably from 2 to 5 % by mole based on the whole structural units constituting the fluorine-containing copolymer. If the content of COOH group is too high, un-exposed portions also become soluble at developing and a resist pattern cannot be formed.

If the content of OH groups or COOH groups (a total of OH groups and COOH groups when the both are present together) becomes too low due to too low dissociation ratio (deprotection ratio), an effect of exhibiting adhesion to a substrate and uniformity of developing becomes insufficient.

Next, explained below is the acid generator in the photosensitive composition to be used in the method of forming a fine resist pattern of the present invention.

In the photosensitive composition to be used in the present invention, examples of the compound (acid generator) generating an acid by irradiation of energy rays are optional compounds which generate an acid by irradiation of, for example, light having a short wavelength such as F₂ excimer laser beam, high energy electron beam, ion beam, X-rays, etc. or a mixture thereof.

Examples of the compound (acid generator) generating an acid by irradiation of energy rays are, for instance, salts such as diazonium salt, phosphonium salt, sulfonium salt, iodonium salt, CF₃SO₃, p-CH₃PhSO₃ and p-NO₂PhSO₃ (Ph represents phenyl), organic halides, orthoquinone-diadidosulfonyl chloride, sulfonic acid ester and the like.

The above-mentioned organic halides are compounds forming hydrohalogenic acids. Examples thereof are those disclosed in USP3,515,551, USP3,536,489, USP3,779,778, DE Patent Publication 2,243,621, etc.

Other compounds generating an acid by irradiation of light mentioned above are disclosed in JP-54-74728A, JP-55-24113A, JP-55-77742A, JP-60-3626A, JP-60-138539, JP-56-17345A and JP-56-36209A.

Examples of those compounds are di(p-tertiarybutylphenyl)iodonium trifluoromethane sulfonate, diphenyliodonium trifluoromethane sulfonate, benzoin tosilate, orthonitrobenzylparatoluene sulfonate, triphenylsulfonium trifluoromethane sulfonate, tri(tertiarybutyl phenyl)sulfonium trifluoromethane sulfonate, benzenediazonium paratoluene sulfonate, 4-(di-n-propylamino)-benzonium tetrafluoroborate, 4-p-tolyl-mercapto-2,5-diethoxy-benzenediazonium hexafluorophosphate, tetrafluoroborate, diphenylamine-4-diazoniumsulfate, 4-methyl-6-trichloromethyl-2-pyrone, 4-(3,4,5-trimethoxy-styryl)-6-trichloromethyl-2-pyrone, 4-(4-methoxy-styryl)-6-(3,3,3-trichloro-propenyl)-2-pyrone, 2-trichloromethyl-benzoimidazole, 2-tribromomethyl-quinoline, 2,4-dimethyl-1-tribromoacetyl-benzene, 4-dibromoacetyl benzoate, 1,4-bis-dibromomethyl-benzene, tris-dibromomethyl-s-triazine, 2-(6-methoxy-naphtyl-2-yl)-4,6-bis-trichloromethyl-s-triazine, 2-(naphtyl-1-yl)-4,6-bis-trichloromethyl-s-triazine, 2-(naphtyl-2-yl)-4,6-bis-trichloromethyl-s-triazine, 2-(4-ethoxyethyl-naphtyl-1-yl)-4,6-bis-trichloromethyl-s-triazine, 2-(benzopyrani-3-yl)-4,6-bis-trichloromethyl-s-triazine, 2-(4-methoxy-anthrasi-1-yl)-4,6-bis-trichloromethyl-s-triazine, 2-(phenanthi-9-yl)-4,6-bis-trichloromethyl-s-triazine, o-naphthoquinonediazide-4-sulfonic acid chloride, and the like. Examples of sulfonic acid ester are naphthoquinonediazide-4-sulfonic acid ester, naphthoquinonediazide-5-sulfonic acid ester, p-toluenesulfonate-2,6-dinitrobenzyl ester and the like.

It is particularly preferable to use o-quinonediazide compound as the compound (acid generator) generating an acid by irradiation of chemical radiation. The above-mentioned o-quinonediazide compound is not limited particularly, and an ester of o-quinonediazide sulfonate and phenol compound is preferred. The ester of o-quinonediazide sulfonate and phenol compound can be prepared through known method by reacting o-quinonediazide sulfonic acid chloride with a phenol compound.

For example, 1-benzophenone-2-diazo-4-sulfonic acid chloride, 1-naphthoquinone-2-diazo-5-sulfonic acid chloride, 1-naphthoquinone-2-diazo-4-sulfonic acid chloride or the like can be used as the above-mentioned o-quinonediazide sulfonic acid chloride.

Examples of the phenol compound which can be used are, for instance, phenol, cresol, xylenol, bisphenol A, bisphenol S, hydroxybenzophenone, 3,3,3',3'-tetramethyl-1,1'-spirobinda-5,6,7,5',6',7'-hexanol, phenolphthalein, dimethyl p-hydroxybenzylidene malonate, dinitrile p-hydroxybenzylidene malonate, cyanophenol, nitrophenol, nitrosophenol, hydroxyacetophenone, methyl trihydroxybenzoate, polyvinylphenol, novolac resin and the like. Examples of the o-quinonediazide compounds are those represented by the following formulae (4) to (8).
formula (4):

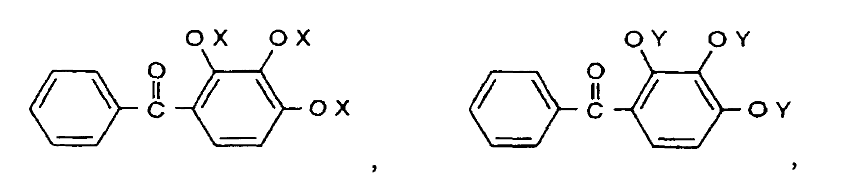

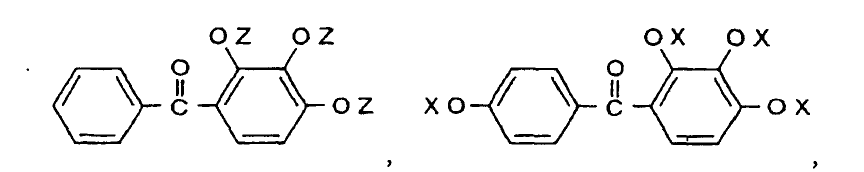

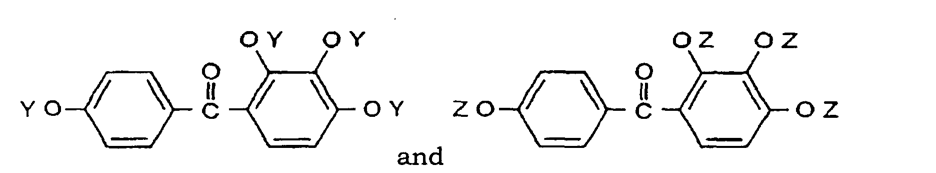

In the above-mentioned formulae, 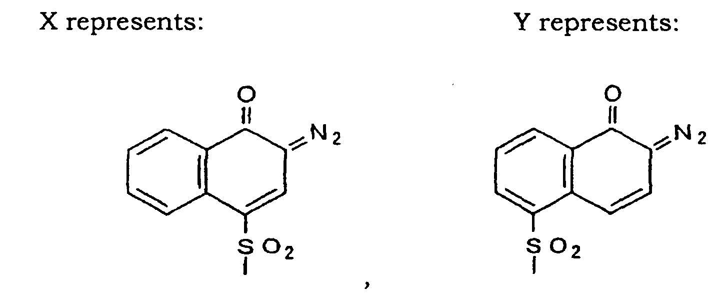 and 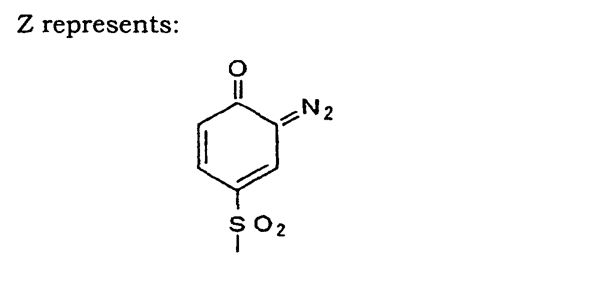 Formula (5):

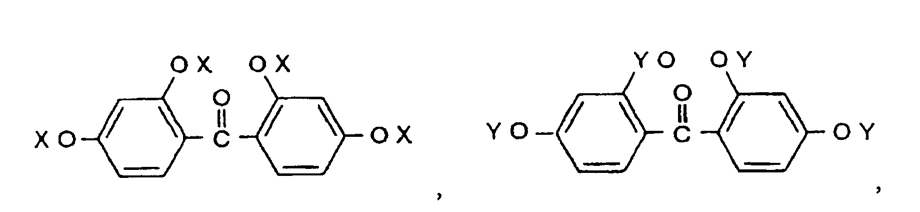

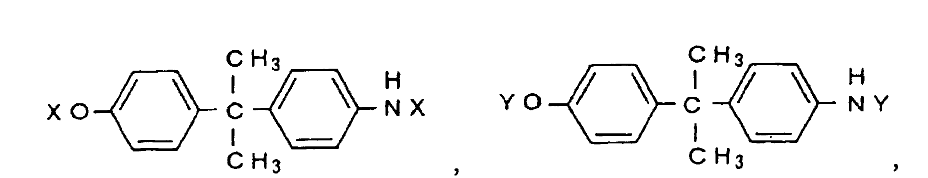

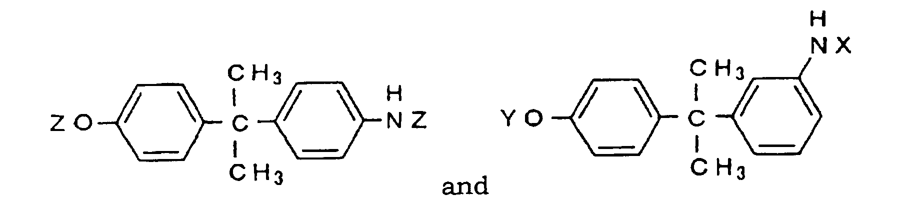

In the above-mentioned formulae, 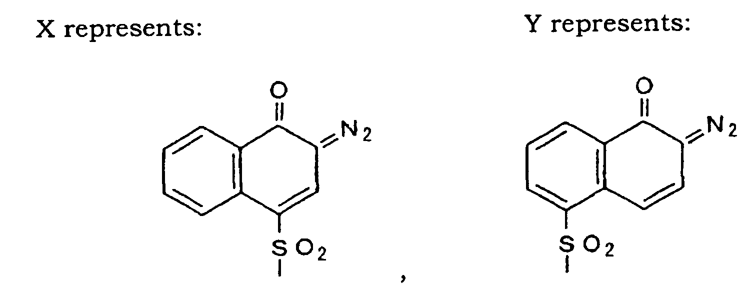 and 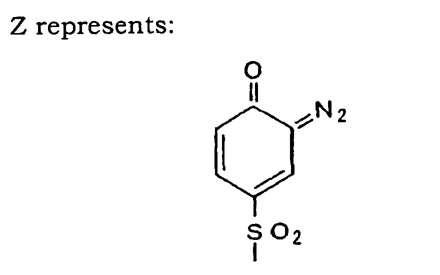 Formula (6): 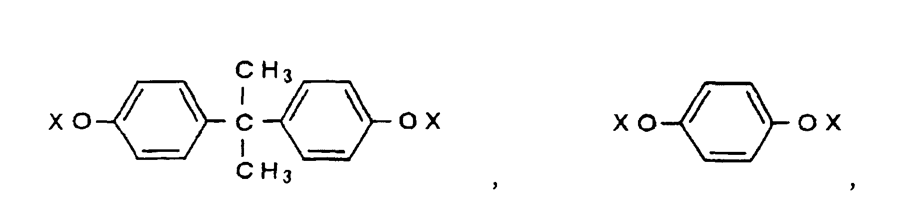 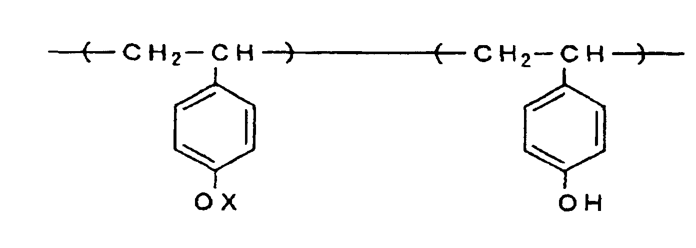 and

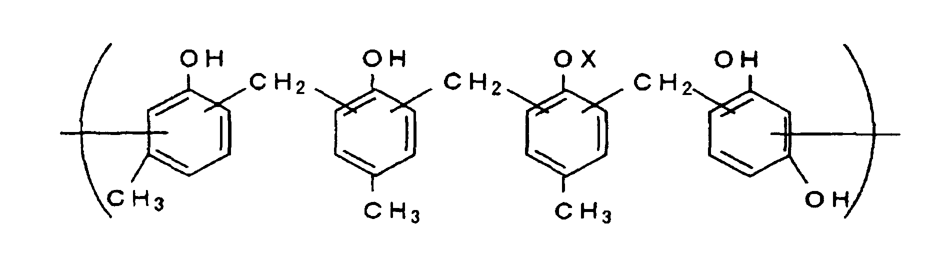

In the above-mentioned formulae, 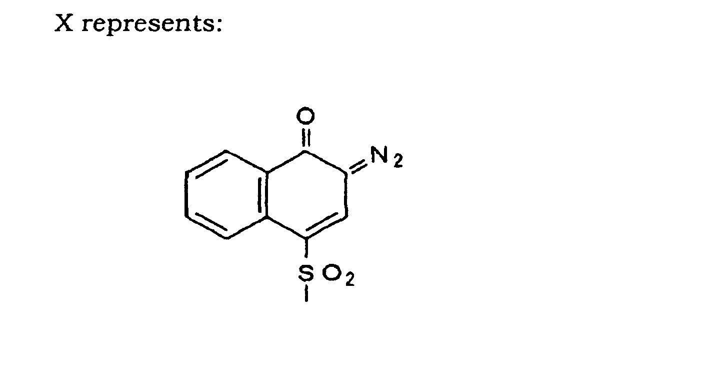 Formula (7):

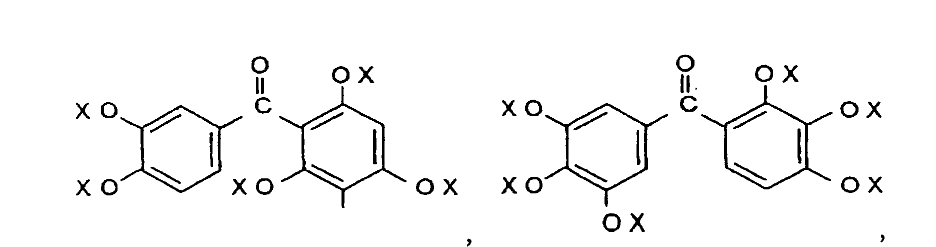

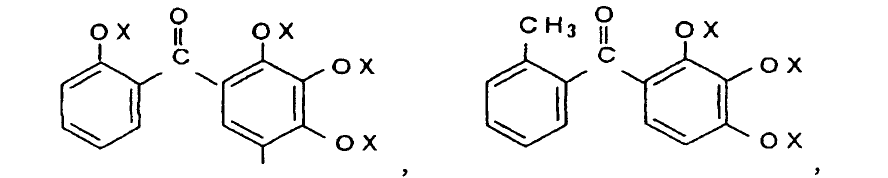

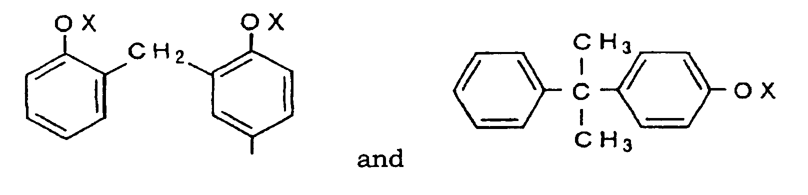

In the above-mentioned formulae, 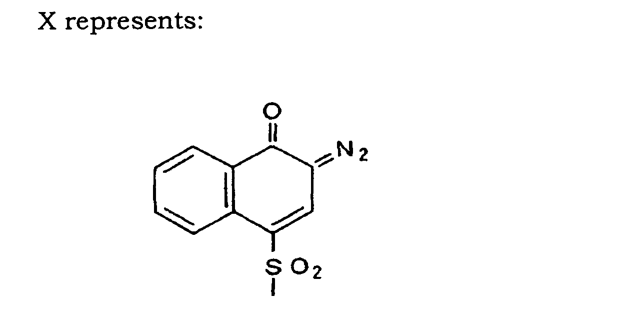 Formula (8):

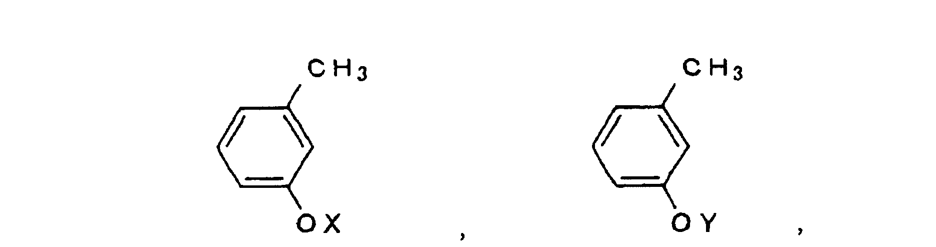

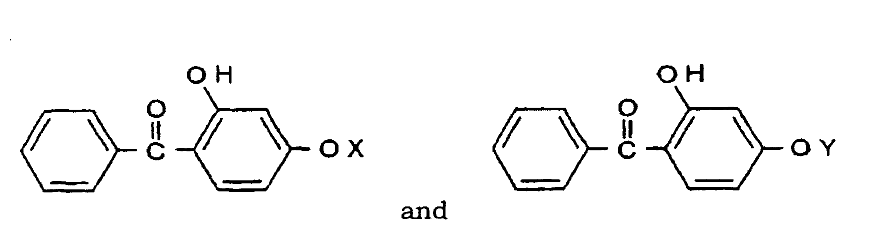

In the above-mentioned formulae,

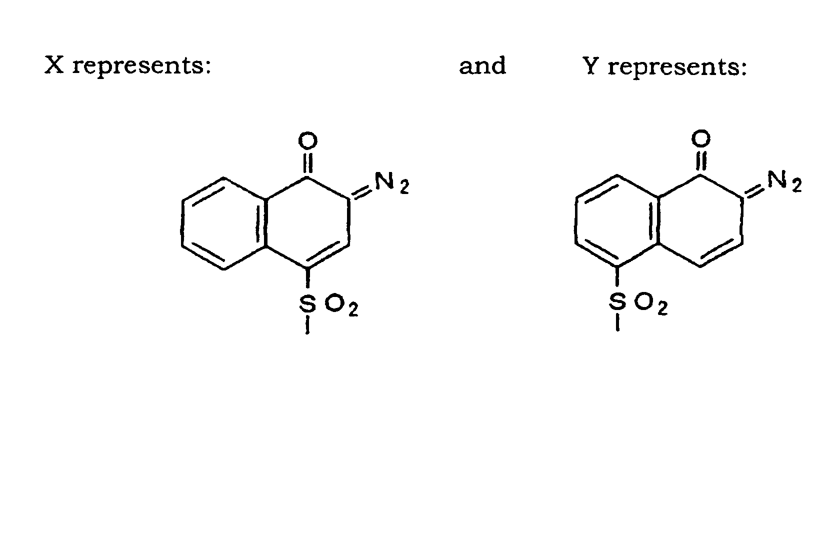

Among the above-mentioned o-quinonediazide compounds, particularly 1-naphthoquinone-2-diazo-4-sulfonic acid ester is suitable. It is known that such an ester generates, by irradiation of light, carboxylic acid and sulfonic acid which is stronger than carboxylic acid as disclosed in J. J. Grimwaid, C. Gal, S. Eidelman, SPIE Vol. 1262, Advances in Resist Technology and Processing VII, p444 (1990), and the ester is particularly effective because of its large catalytic action.

As the above-mentioned compound (acid-generator) which generates an acid by irradiation of the chemical radiation, there can be suitably used the compounds (A-1), (A-2) and (A-3) represented by the following formulae (9), (10) and (11), respectively.
Formula (9):

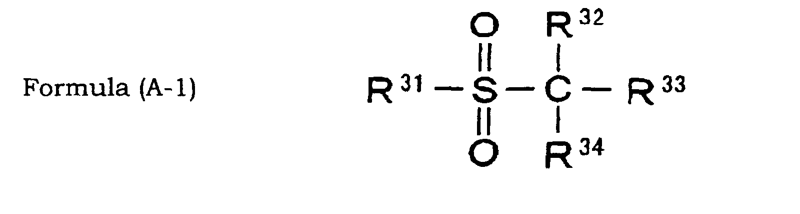

In the above formula (A-1), R³¹ represents a monovalent organic group or a monovalent organic group to which at least one selected from the group consisting of halogen atom, nitro group and cyano group is introduced, R³², R³³ and R³⁴ independently represent hydrogen atom, halogen atom, nitro group, cyano group, a monovalent organic group or a monovalent organic group to which at least one selected from the group consisting of halogen atom, nitro group and cyano group is introduced.
Formula (10):

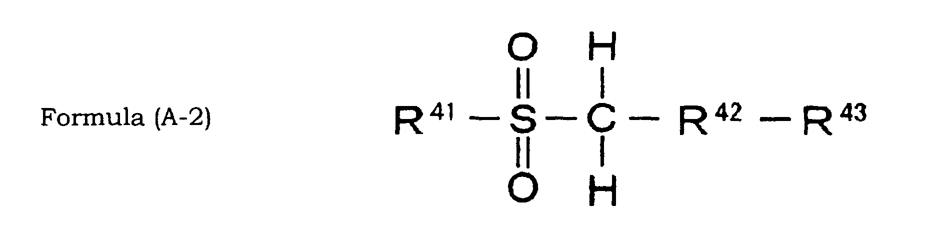

In the formula (A-2), R⁴¹ and R⁴³ independently represent a monovalent organic group or a monovalent organic group to which at least one selected from the group consisting of halogen atom, nitro group and cyano group is introduced, R⁴² represents a sulfonyl group or carbonyl group.
Formula (11):

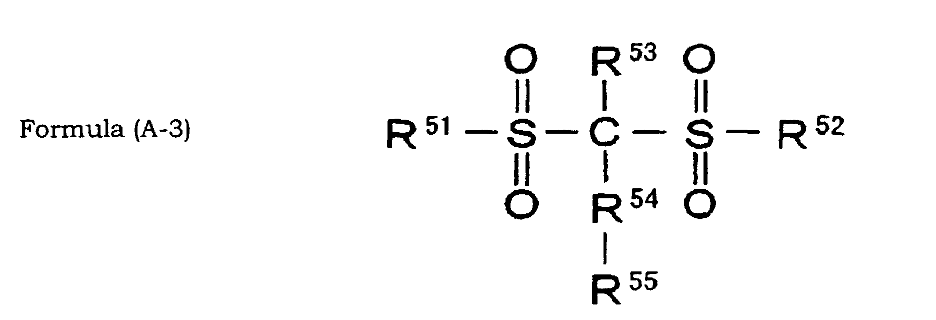

In the above formula (A-3), R⁵¹, R⁵² and R⁵⁵ independently represent a monovalent organic group or a monovalent organic group to which at least one selected from the group consisting of halogen atom, nitro group and cyano group is introduced, R⁵³ represents hydrogen atom, a monovalent organic group or a monovalent organic group to which at least one selected from the group consisting of halogen atom, nitro group and cyano group is introduced, R⁵⁴ represents a sulfonyl group, sulfinyl group, sulfur atom or carbonyl group.

Examples of the monovalent organic group which is introduced to the compound of the formula (A-1) as R³¹, R³², R³³ and R³⁴ are allyl, anisyl, anthraquinonyl, acetonaphthyl, anthryl, azulenyl, benzofuranyl, benzoquinonyl, benzoxadinyl, benzoxazoryl, benzyl, biphenylenyl, bornyl, butenyl, butyl, cinnamyl, cresotoyl, cumenyl, cyclobutanedienyl, cyclobutenyl, cyclobutyl, cyclopentadienyl, cyclopentatolyenyl, cycloheptyl, cyclohexenyl, cyclopentyl, cyclopropyl, cyclopropenyl, desyl, dimethoxyphenetyl, diphenylmethyl, docosyl, dodecyl, eicosyl, ethyl, fluorenyl, furfuryl, geranyl, heptyl, hexadecyl, hexyl, hydroxymethyl, indanyl, isobutyl, isopropyl, isopropylbenzyl, isoxazolyl, menthyl, mesityl, methoxybenzyl, methoxyphenyl, methyl, methylbenzyl, naphthyl, naphthylmethyl, nonyl, norbornyl, octacosyl, octyl, oxazinyl, oxazolidinyl, oxazolinyl, oxazolyl, pentyl, phenacyl, phenanthryl, phenetyl, phenyl, phthalidyl, propynyl, propyl, pyranyl, pyridyl, quinazolinyl, quinolyl, salicyl, terephthalyl, tetrazolyl, thiazolyl, thiaphtenyl, thienyl, tolyl, trityl, trimethylsilylmethyl, trimethylsilyloxymethyl, undecyl, valeryl, veratryl, xylyl and the like.

Examples of the monovalent organic group to which at least one selected from the group consisting of halogen atom, nitro group and cyano group is introduced are the above-mentioned groups in which hydrogen atom is replaced.

Examples of the compound of the above-mentioned formula (A-1) are phenyl methyl sulfone, ethyl phenyl sulfone, phenyl propyl sulfone, methyl benzyl sulfone, benzyl sulfone (dibenzyl sulfone), methyl sulfone, ethyl sulfone, butyl sulfone, methyl ethyl sulfone, methyl sulfonyl acetonitrile, phenylsulfonyl acetonitrile, toluenesulfonyl acetonitrile, benzyl phenyl sulfone, nitrophenyl sulfonyl acetonitrile, fluorophenyl sulfonyl acetonitrile, chlorophenyl sulfonyl acetonitrile, methoxyphenyl sulfonyl acetonitrile, α-methylphenyl sulfonyl acetonitrile, ethylsulfonyl acetonitrile, methylthiomethyl-p-toluyl sulfone, phenylsulfonyl acetophenone, phenylsulfonyl propionitrile, phenylsulfonyl propionate and ester compounds thereof, bromomethyl-2-(phenylsulfonylmethyl) benzene, naphthylmethylsulfone, 1-methyl-2-((phenylsulfonyl)methyl)benzene, trimethyl-3-(phenylsulfonyl)orthopropionate and the like.

In the present invention, among the compounds of the above-mentioned formula (A-1), preferred are those in which at least one of R³², R³³ and R³⁴ is an electron attractive group. Particularly preferred is one having cyano group from the viewpoint of a high efficiency of acid generation at exposing and enhancement of sensitivity of a photosensitive composition (resist).

Also the compound in which at least one of R³², R³³ and R³⁴ is hydrogen atom is preferred because solubility in alkali is high and generation of a scum is reduced when a developing treatment is carried out using an alkali solution for developing a resist.

In the compounds of the above-mentioned formula (A-1), a ring may be formed by bonding of R³¹ to R³², R³³ or R³⁴ or bonding of R³², R³³ and R³⁴ to each other. In that case, examples of the formed cyclic compound are thiopyrandioxide compounds such as phenylsulfonyl tetrahydropyran, phenylsulfonyl cyclohexane, 3-phenyl-2H-thiopyran-1,1-dioxide and 6-methyl-3-phenyl-2H-thiopyran-1,1-dioxide, biscyclictrisulfone compounds such as trimethylene sulfone, tetramethylene sulfone and 4-methyl-2,6,7-trithiabicyclo[2,2,2]-octane-2,2,6,6,7,7-hexaoxide, and compounds represented by the following formula (12).
Formula (12):

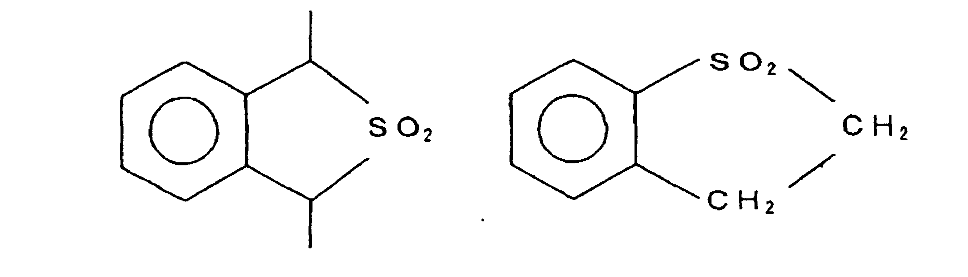

The compound of the above-mentioned formula (A-2) is an organic compound in which to a specific carbon atom are bonded two sulfonyl groups or one sulfonyl group and one carbonyl group. Examples of the monovalent organic groups which are introduced as R⁴¹ and R⁴³ to the compound (A-2) are the same as the groups raised as the monovalent organic groups which are introduced to the above-mentioned compound (A-1). Also hydrogen atom of those organic groups may be replaced with at least one selected from the group consisting of halogen atom, nitro group and cyano group.

Examples of the above-mentioned compound (A-2) are bis(phenylsulfonyl)methane, bis(methylsulfonyl)methane, bis(ethylsulfonyl)methane, (methylsulfonyl)(phenylsulfonyl)methane, phenylsulfonyl acetophenone, methylsulfonyl acetophenone and the like.

In the compound (A-2), too, R⁴¹ and R⁴³ may be bonded to each other to form a ring. In that case, examples of the formed cyclic compound are, for instance, cyclic sulfone compounds represented by the following formula (13).
Formula (13):

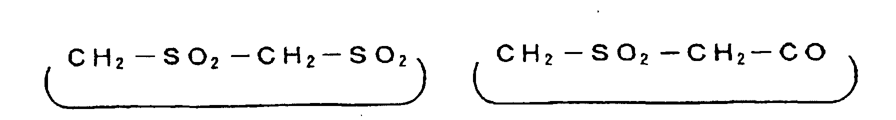

In the present invention, the above-mentioned compound (A-2) is a more preferred acid-generator because an alkali solubility and an efficiency of acid generation at exposing are high and sensitivity of a photosensitive composition (resist) is enhanced.

The above-mentioned compound (A-3) which is used as an acid-generator is an organic compound in which to a specific carbon atom are bonded at least two sulfonyl groups and further a linkage group having sulfur atom and one carbonyl group. Examples of the monovalent organic groups which are introduced as R⁵¹, R⁵², R⁵³ and R⁵⁵ to the compound (A-3) are the same as the groups raised as the monovalent organic groups which are introduced to the above-mentioned compound (A-1). Further hydrogen atom of those organic groups may be replaced with at least one selected from the group consisting of halogen atom, nitro group and cyano group, hydroxyl, carboxyl or esterified carboxyl. Examples of preferred R⁵⁴ are sulfonyl group, sulfinyl group and sulfur atom.

Examples of the above-mentioned compound (A-3) are tris(phenylsulfonyl)methane, phenylthio-bis(phenylsulfonyl)-methane, phenylmercapto-bis(methylsulfonyl)-methane, tris(methylsulfonyl)methane, tris(ethylsulfonyl)methane, bis(phenylsulfonyl)-methylsulfonyl-methane, bis(methylsulfonyl)-phenylsulfonyl-methane, phenylsulfonyl-ethylsulfonyl-methylsulfonyl-methane, tris(4-nitophenylsulfonyl)methane, tris(2,4-nitrophenylsulfonyl)methane, bis(phenylsulfonyl)-(4-nitrophenylsulfonyl)-methane, bis(phenylsulfonyl)-(3-nitrophenylsulfonyl)-methane, bis(phenylsulfonyl)-(2-nitrophenylsulfonyl)-methane, bis(phenylsulfonyl)-(p-tolylsulfonyl)-methane, bis(methylsulfonyl)-(4-nitrophenylsulfonyl)-methane, bis(methylsulfonyl)-(4-chlorophenylsulfonyl)-methane, bis(phenylsulfonyl)-(4-chlorophenylsulfonyl)-methane, 1,1,1-tris(phenylsulfonyl)ethane and the like.

In the above-mentioned compounds (A-1), (A-2) and (A-3), it is preferable that, for example, at least one of R³¹, R⁴¹ and R⁴³ or at least one of R⁵¹, R⁵² and R⁵⁵ is an aromatic group from the point that particularly when exposing is carried out using excimer laser beam, dry etching resistivity and heat resistance of the photosensitive composition are enhanced. In addition, the acid-generators having a melting point of not less than 50°C and a high solubility in an organic solvent are also preferred.

On the other hand, when the compounds (A-1), (A-2) and (A-3) are the sulfonyl compounds having a basic substituent such as sulfone amide, there is a case where an acid generated by the exposing is inactivated. Also in case of a sulfonyl compound having an acid group having a high solubility in alkali such as sulfonic acid, there is a case where solubility in alkali at an un-exposed portion of the photosensitive composition is increased excessively. Therefore with respect to the sulfonyl compounds, there is a case where use thereof as an acid-generator in the composition is strictly limited in the present invention.

An adding amount of the acid-generator is preferably from 0.05 to 30 parts by weight, more preferably from 0.1 to 10 parts by weight based on 100 parts by weight of the whole photosensitive composition.

The reason for this is such that if the amount of the acid-generator is too small, an acid enough for initiating a catalytic reaction is not generated and therefore the catalytic reaction by the generated acid is not advanced and sufficient photosensitivity is hardly imparted to the photosensitive composition. On the other hand, if the amount of the acid-generator is too large, a glass transition point and coatability of the photosensitive composition are lowered, which results in a fear that heat resistance and strength of the obtained resist pattern are lowered and a residue of the acid-generator is generated after the developing or after the etching.

Also if the adding amount thereof in the photosensitive composition is too large, particularly when the photosensitive composition is exposed to F₂ excimer laser beam having a wavelength of 157 nm, since some of the above-mentioned acid-generators have a high absorption at a wavelength of exposure light, transmittance of beam through the photosensitive composition is significantly lowered and uniform exposing is difficult.

Those acid-generators may be used solely or in a mixture of two or more thereof.

In the chemically amplifying resist, there is known a method of controlling a distance of scattering an acid in the photosensitive composition and increasing resolution by adding a basic substance. In the photosensitive composition of the present invention, too, the same effect can be expected. In that case, an adding amount of the basic substance is preferably from 0.05 to 10 parts by weight, more preferably from 0.5 to 5 parts by weight based on 100 parts by weight of the acid-generator. If the amount is smaller than the above-mentioned amount, sufficient effect cannot be produced and on the contrary, if the amount is larger than the above-mentioned amount, much of the generated acid is neutralized and inactivated, and therefore sensitivity of the photosensitive composition is significantly lowered.

Then the solvent for the photosensitive composition used in the method of forming a fine pattern of the present invention is explained below.

The photosensitive resin (photosensitive composition) which is used in the present invention can be prepared by dissolving, in a given solvent, an alkali soluble resin and a compound (acid-generator) which generates an acid by irradiating with energy rays such as F₂ excimer laser beam.

The solvent is not limited particularly as far as it can be usually used as a solvent for a photosensitive composition. Non-limiting examples thereof are, for instance, ketone solvents such as cyclohexanone, acetone, methyl ethyl ketone (2-butanone), methyl isobutyl ketone and 2-heptanone; cellosolve solvents such as methyl cellosolve, methyl cellosolve acetate, ethyl cellosolve and ethyl cellosolve acetate; ester solvents such as ethyl acetate, butyl acetate, isoamyl acetate, ethyl lactate and γ-butyrolactone; lactone solvents; glycol solvents such as propylene glycol monomethylether acetate (PGMEA); dimethyl sulfoxide; N-methylpyrrolidone; and the like.

Those solvents may be used solely or as a solvent mixture comprising two or more thereof.

The solvent mixture may contain a proper amount of, for example, aromatic hydrocarbon such as xylene or toluene, aliphatic alcohol such as ethanol and isopropyl alcohol (2-propanol) or a solvent derived therefrom.

Among the above-mentioned solvents, preferred is propylene glycol monomethylether acetate (PGMEA). Since a trace amount of the solvent remaining in the photosensitive composition affects characteristics of the photosensitive composition, PGMEA is suitable from the viewpoint of its boiling point, solubility parameter and polarity.

In addition to propylene glycol monomethylether acetate (PGMEA), ethyl lactate is also preferable as a solvent for the photosensitive composition.

Next, the method of forming a pattern of the present invention is explained by means of the drawing.

Mentioned below is the explanation in case where the photosensitive composition obtained from a fluorine-containing resin is used as a positive type resist.

Fig. 1 is a cross-sectional view showing the method of forming the fine pattern of the present invention using the photosensitive composition obtained from a fluorine-containing resin.

First, as shown in Fig. 1(a), the photosensitive composition obtained from a fluorine-containing resin is coated on a substrate 11 by a rotary coating method or the like in a coating thickness of from 0.01 to 5 µm, preferably from 0.05 to 0.5 µm, more preferably from 0.1 to 0.3 µm.

Next, pre-baking treatment is carried out at a pre-determined temperature of not more than 150°C, preferably from 80° to 130°C to form a resin layer (layer of photosensitive composition), namely a resist layer 12.

Non-limiting examples of the above-mentioned substrate are, for instance, a silicon wafer, silicon wafer provided with various insulation films, electrode and wiring and having steps, mask blank, semiconductor wafer of III-V group compound such as GaAs and AlGaAs, semiconductor wafer of II-VI group compound, piezoelectric wafer of crystal, quartz or lithium tantalate and the like.

Then as shown in Fig. 1(b), a pattern is drawn on the resist layer 12 by irradiating energy rays such as F₂ excimer laser beam as shown by an arrow 15 through a mask pattern 13 having a desired pattern and thus selectively exposing a specific area 14.

In that case, it is possible to generally use, as an exposure light, energy rays (or chemical radiation), namely, X-ray, high energy electron beam, synchrotron radiation, characteristic radiation of high pressure mercury lamp, excimer laser beam other than F₂ excimer laser beam or the like or to scan electron beam, ion beam or the like without using the mask to directly expose the resist film to the pattern. The effect of the present invention is exhibited most when F₂ excimer laser beam is used as exposure light.

Subsequently by carrying out baking at a temperature of from 70° to 160°C, preferably from 90° to 140°C, for about 30 seconds to about 10 minutes after the exposing, a latent image 16 is formed on the exposed area 14 of the resist film as shown in Fig. 1(c). At that time, an acid generated by the exposing acts as a catalyst to decompose the dissolution-inhibiting group (dissolution inhibitor) and thereby solubility in alkali is increased and the exposed area of the resist film becomes soluble in an aqueous alkali solution.

Then when the resist film 12 baked after the exposing is subjected to developing with an aqueous alkali solution, the un-exposed area of the resist film 12 remains on the substrate because its solubility in the aqueous alkali solution is low but the exposed area 14 is dissolved in the developing solution as mentioned above.

Next, after flowing away the developing solution with pure water, lower alcohol or a mixture thereof, the substrate is dried and thus a desired resist pattern 17 can be formed as shown in Fig. 1(d).

Mentioned above is the explanation in case of the positive type chemically amplifying resist, but also when the photosensitive composition is used on the negative type resist, since an acid generated by the exposing participates in the reaction of the alkali soluble resin with a crosslinking agent and also the reaction of making the resin insoluble in alkali by changing a structure of a substituent, there can be obtained such an effect that a pattern can be formed in high sensitivity like the above-mentioned case of positive type resist.

While the above-mentioned explanation is made with respect to the case of using F₂ excimer laser beam as the energy ray, ArF excimer laser beam is also suitable as the energy ray used for the method of forming a fine pattern of the present invention.

Also KrF excimer laser beam is suitable as the energy ray used for the method of forming a fine pattern of the present invention.

High energy electron beam is also suitable as the energy ray used for the method of forming a fine pattern of the present invention.

Also high energy ion beam is suitable as the energy ray used for the method of forming a fine pattern of the present invention.

Also X-ray generated from synchrotron radiation is suitable as the energy ray used for the method of forming a fine pattern of the present invention.

Though the above-mentioned explanation is made with respect to the case of forming the resist film on the substrate 11, the formation of the resist film is not limited to the case of forming the resist film on a so-called substrate. The resist film may also be formed on an electrically conductive film, insulating film or the like which is formed on the substrate. Also it is possible to form an antireflection film, for example, DUV-30, DUV-32, DUV-42 and DUV44 available from Brewer Science Co., Ltd. on the substrate. The resist film may be formed on a substrate treated with an adhesion improver. The substrate is also not limited to those for production of semiconductor devices and includes various substrates for production of electronic devices, etc. as mentioned above.

Also when an intended fine pattern of an electrically conductive film or an insulating film is formed by using the so-formed fine resist pattern as a mask and etching a specific layer under the mask and then other steps are carried out, semiconductor devices and electronic devices can be produced. Since those steps are well known, explanation thereof is omitted.

The present invention is then explained by means of examples and comparative examples, but is not limited to them.

### PREPARATION EXAMPLE 1

### (Synthesis of copolymer of TFE and fluorine-containing norbornene having OH group)

A 300 ml autoclave equipped with a valve, pressure gauge and thermometer was charged with 20.7 g of a fluorine-containing norbornene (M2-1) having OH group: 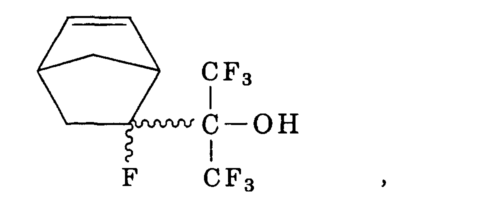 140 ml of HCFC-141b and 1.5 g of bis(4-t-butylcyclohexyl)peroxydicarbonate (TCP), and while cooling with dry ice/methanol solution, the inside of a system was sufficiently replaced with nitrogen gas. Then 30.0 g of TFE was introduced through the valve, followed by shaking for reaction at 40°C for 12 hours. With the advance of the reaction, a gauge pressure was decreased from 0.96 MPaG (9.7 kgf/cm²G) before the reaction to 0.91 MPaG (9.2 kgf/cm²G).

After releasing the un-reacted monomer, the polymerization solution was removed, followed by concentration and re-precipitation with hexane to separate a copolymer. Until a constant weight was reached, vacuum drying was continued and 4.1 g of a copolymer was obtained.

As a result of ¹H-NMR and ¹⁹F-NMR analyses, the copolymer was one comprising TFE/the above-mentioned fluorine-containing norbornene derivative (M2-1) having OH group in a percent by mole ratio of 50/50.

According to GPC analysis, a number average molecular weight of the copolymer was 3,500.

### PREPARATION EXAMPLE 2

### (Synthesis of copolymer comprising TFE and fluorine-containing norbornene derivative having -OCH₂OC₂H₅ group)

A reaction was carried out in the same manner as in preparation Example 1 except that 26.2 g of a fluorine-containing norbornene derivative (M2-2) having -OCH₂OC₂H₅ group: 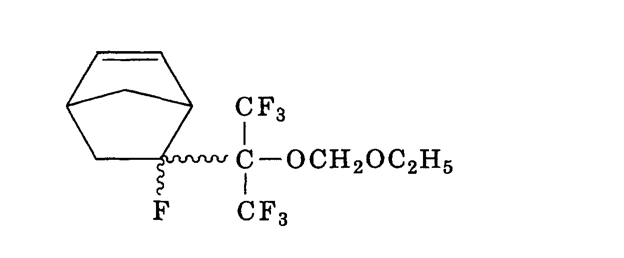 was used instead of the fluorine-containing norbornene derivative (M2-1) having OH group. With the advance of the reaction, a gauge pressure was lowered from 0.94 MPaG (9.5 kgf/cm²G) before the reaction to 0.91 MPaG (9.2 kgf/cm²G). Then separation and refining were carried out in the same manner as in Preparation Example 1 and 3.9 g of a copolymer was obtained.

As a result of ¹H-NMR and ¹⁹F-NMR analyses, the copolymer was a copolymer of TFE/the above-mentioned fluorine-containing norbornene derivative (M2-2) having -OCH₂OC₂H₅ group in a percent by mole ratio of 50/50.

According to GPC analysis, a number average molecular weight thereof was 2,600.

### PREPARATION EXAMPLE 3

### (Synthesis of copolymer comprising TFE, fluorine-containing norbornene derivative having -OCH₂OC₂H₅ group and 2-norbornene)

A reaction was carried out in the same manner as in preparation Example 1 except that 18.5 g of the fluorine-containing norbornene derivative (M2-2) having -OCH₂OC₂H₅ group was used instead of the fluorine-containing norbornene derivative (M2-1) having OH group and 2.1 g of 2-norbornene was used. Then separation and refining were carried out in the same manner as in Preparation Example 1 and 4.3 g of a copolymer was obtained.

As a result of ¹H-NMR and ¹⁹F-NMR analyses, the copolymer was a copolymer of TFE/the above-mentioned fluorine-containing norbornene derivative (M2-2) having -OCH₂OC₂H₅ group/2-norbornene in a percent by mole ratio of 56/31/13.

According to GPC analysis, a number average molecular weight thereof was 3,200.

### PREPARATION EXAMPLE 4

### (Synthesis of copolymer comprising TFE, fluorine-containing norbornene derivative having -OH group and fluorine-containing norbornene derivative having -COOC(CH₃)₃ group)

A 500 ml autoclave equipped with a valve, pressure gauge, stirrer and thermometer was charged with 3.1 g of the above-mentioned fluorine-containing norbornene derivative (M2-1) having -OH group, 21.0 g of a fluorine-containing norbornene derivative (N-1) having -COOC(CH₃)₃ group: 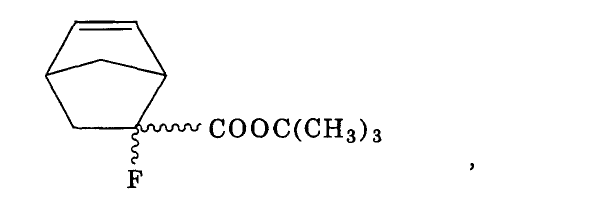 250 ml of HCFC-141b and 6.6 g of bis(4-t-butylcyclohexyl)peroxydicarbonate (TCP), and the inside of a system was sufficiently replaced with nitrogen gas. Then 44 g of TFE was introduced through the valve, followed by shaking at 40°C for 12 hours for reaction.

After releasing the un-reacted monomer, the polymerization solution was removed and after concentrating, was re-precipitated with hexane to separate a copolymer. Until a constant weight was reached, vacuum drying was carried out to obtain 6.9 g of a copolymer.

As a result of ¹H-NMR and ¹⁹F-NMR analyses, the copolymer was a copolymer of TFE/fluorine-containing norbornene derivative (M2-1) having -OH group/fluorine-containing norbornene derivative (N-1) having -COOC(CH₃)₃ group in a percent by mole ratio of 54/9.2/36.8.

According to GPC analysis, a number average molecular weight thereof was 2,800.

### PREPARATION EXAMPLE 5

### (Synthesis of copolymer comprising TFE, fluorine-containing norbornene derivative having -OH group and fluorine-containing norbornene derivative having -COOC(CH₃)₃ group)

A reaction was carried out in the same manner as in Preparation Example 4 except that 9.2 g of the fluorine-containing norbornene derivative (M2-1) having OH group and 16.3 g of the fluorine-containing norbornene derivative (N-1) having -COOC(CH₃)₃ group were used. Then separation and refining were carried out in the same manner as in Preparation Example 4 and 7.2 g of a copolymer was obtained.

As a result of ¹H-NMR and ¹⁹F-NMR analyses, the copolymer was a copolymer of TFE/fluorine-containing norbornene derivative (M2-1) having -OH group/fluorine-containing norbornene derivative (N-1) having -COOC(CH₃)₃ group in a percent by mole ratio of 52/29/19.

According to GPC analysis, a number average molecular weight thereof was 3,300.

### EXAMPLE 1

A vacuum ultraviolet absorption spectrum of the fluorine-containing copolymers obtained in Preparation Examples 1 to 5 was measured. An absorption coefficient per 1 µm at 157 nm of the fluorine-containing copolymers obtained in each Preparation Example is shown in Table 1.

**TABLE 1**

| Fluorine-containing copolymer | Absorption coefficient (µm⁻¹) |
|---|---|
| Prep. Ex. 1 | 1.6 |
| Prep. Ex. 2 | 1.7 |
| Prep. Ex. 3 | 1.8 |
| Prep. Ex. 4 | 2.6 |
| Prep. Ex. 5 | 2.1 |

### EXAMPLE 2

### (Evaluation of dry etching resistivity)

Propylene glycol monomethylether acetate (PGMEA) solutions of 10 % by weight of fluorine-containing polymers obtained in Preparation Examples 1 to 5, respectively were prepared and coated on a silicon wafer with a spin coater so that the coating thickness became about 200 nm. The coating film was pre-baked at 110°C for one minute to obtain a coated silicon substrate. A coating thickness of the fluorine-containing copolymer film on the substrate was measured with an optical film thickness meter (Lambda Ace available from Dai-Nippon Screen Seizo Kabushiki Kaisha).

Then the coated silicon substrate was subjected to etching at an etching time of 60 seconds under the following etching conditions.

### (Etching conditions)

Equipment: Model IEM etching machine (available from Tokyo Electron Kabushiki Kaisha)
Pressure: 30 mTorr
Flow rate: Ar (400 sccm)/C₄F₈ (11 sccm)/O₂ (8 sccm)
Plasma conditions: 2,000 W, 27 MHz (upper electrode)
   1,200 W, 800 kHz (lower electrode)
Gap: 20 mm
Temperature: Upper temperature of 30°C, Wall temperature of 40°C,
   Electrode temperature of -20°C
Back pressure: 10 Torr (center)/35 Torr (edge)

A coating thickness of the fluorine-containing copolymer film on the substrate after the etching was measured with an optical film thickness meter (Lambda Ace available from Dai-Nippon Screen Seizo Kabushiki Kaisha), and an etching rate was calculated from the film thickness before the etching. The results are shown in Table 2.

An etching rate of ArF resist (AX-431 available from Sumitomo Chemical Industries, Ltd.) was measured for comparison under the same etching conditions as above. The etching rate (RIE rate) of the fluorine-containing copolymers of Preparation Examples 1 to 5 was calculated provided that the etching rate of ArF resist was 1. The results are shown in Table 2.

**TABLE 2**

| Fluorine-containing copolymer | Etching rate (nm/min) | RIE rate |
|---|---|---|
| Prep. Ex. 1 | 90.2 | 0.95 |
| Prep. Ex. 2 | 84.2 | 0.89 |
| Prep. Ex. 3 | 86.3 | 0.91 |
| Prep. Ex. 4 | 83.7 | 0.88 |
| Prep. Ex. 5 | 85.1 | 0.90 |
| ArF resist | 95.0 | 1 |

### EXAMPLE 3

Triphenylsulfonium triflate was added as a photoacid generator in an amount of 5 parts by weight to 100 parts by weight of the fluorine-containing copolymer prepared in Preparation Example 2, followed by dissolving in PGMEA. The obtained solution of photosensitive composition was applied on a silicon wafer with a spin coater and was dried at 110°C for 90 seconds to form a 0.1 µm thick resist film

This resist film was subjected to frame exposure on a spot of 1 cm × 1 cm square (1 cm²) by using F₂ excimer laser beam (wavelength 157 nm). After the exposing, heating was carried out on a heated plate at 110°C for 90 seconds, followed by developing with an aqueous solution of tetramethylammonium hydroxide (TMAH) having a concentration of 2.38 % by weight.

When the above-mentioned frame exposure, heating and developing were carried out in the same manner as above by changing exposure energy of F₂ excimer laser beam from 0.1 mJ/cm² to 100 mJ/cm², the spot of 1 cm² was completely dissolved at the exposure of not less than 6.3 mJ/cm², from which it was known that the fluorine-containing copolymer prepared in Preparation Example 2 had sensitivity which could make the copolymer function as a positive type resist.

The above-mentioned procedures were repeated by using a reduction projection exposure system using F₂ laser as light source. As a result, a 130 nm fine pattern could be produced at an exposure energy of 12 mJ/cm². From this, it was known that the fluorine-containing resin prepared in Preparation Example 2 had resolution which could make the copolymer function as a positive type resist.

### EXAMPLE 4

A photosensitive composition was prepared and a resist film was formed in the same manner as in Example 3 except that the fluorine-containing copolymer obtained in Preparation Example 4 was used instead of the fluorine-containing copolymer obtained in Preparation Example 2. Then frame exposure using F₂ laser beam, heating and developing were carried out in the same manner as above.

As a result, the spot of 1 cm² was completely dissolved at an exposure energy of not less than 2.1 mJ/cm², from which it was known that the fluorine-containing copolymer prepared in Preparation Example 4 had sensitivity which could make the copolymer function as a positive type resist.

The above-mentioned procedures were repeated by using a reduction projection exposure system using F₂ laser as light source. As a result, a 120 nm fine pattern could be produced at an exposure energy of 3 mJ/cm². From this, it was known that the fluorine-containing resin prepared in Preparation Example 4 had resolution which could make the copolymer function as a positive type resist.

### PREPARATION EXAMPLE 6

### (Synthesis of copolymer of TFE and fluorine-containing norbornene having OH group)

A 500 ml autoclave equipped with a valve, pressure gauge, stirrer and thermometer was charged with 35.0 g of the fluorine-containing norbornene (M2-1) having OH group: 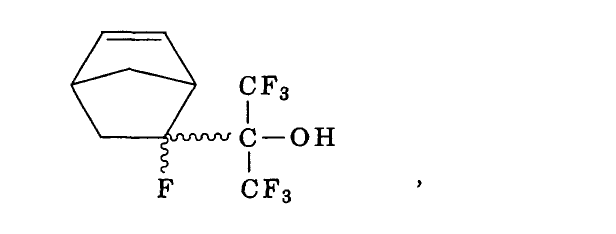 250 ml of HCFC-141 b and 6.5 g of bis(4-t-butylcyclohexyl)peroxydicarbonate (TCP), and while cooling with dry ice/methanol solution, the inside of a system was sufficiently replaced with nitrogen gas. Then 52.0 g of TFE was introduced through the valve, followed by stirring for reaction at 40°C for 12 hours. With the advance of the reaction, a gauge pressure was decreased from 0.96 MPaG (9.7 kgf/cm²G) before the reaction to 0.91 MPaG (9.2 kgf/cm²G).

After releasing the un-reacted monomer, the polymerization solution was removed, followed by concentration and re-precipitation with hexane to separate a copolymer. Until a constant weight was reached, vacuum drying was continued and 6.0 g of a copolymer was obtained.

As a result of ¹H-NMR and ¹⁹F-NMR analyses, the copolymer was one comprising TFE/the above-mentioned fluorine-containing norbornene derivative (M2-1) having OH group in a percent by mole ratio of 50/50.

According to GPC analysis, a number average molecular weight of the copolymer was 5,500.

### PREPARATION EXAMPLE 7

### (Synthesis of copolymer comprising TFE and fluorine-containing norbornene derivative having -OCH₂OC₂H₅ group)

A reaction was carried out in the same manner as in preparation Example 6 except that 40.0 g of the fluorine-containing norbornene derivative (M2-2) having -OCH₂OC₂H₅ group: 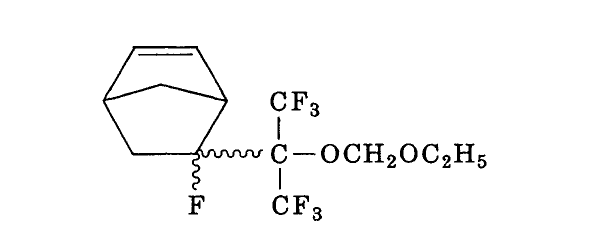 was used instead of the fluorine-containing norbornene derivative (M2-1) having OH group. With the advance of the reaction, a gauge pressure was lowered from 0.94 MPaG (9.5 kgf/cm²G) before the reaction to 0.91 MPaG (9.2 kgf/cm²G). Then separation and refining were carried out in the same manner as in Preparation Example 1 and 7.5 g of a copolymer was obtained.

As a result of ¹H-NMR and ¹⁹F-NMR analyses, the copolymer was a copolymer of TFE/the above-mentioned fluorine-containing norbornene derivative (M2-2) having -OCH₂OC₂H₅ group in a percent by mole ratio of 50/50.

According to GPC analysis, a number average molecular weight thereof was 4,600.

### PREPARATION EXAMPLE 8

### (Synthesis of copolymer comprising TFE, fluorine-containing norbornene derivative having -OH group and fluorine-containing norbornene derivative having -OCH₂OC₂H₅ group)

A 500 ml autoclave equipped with a valve, pressure gauge, stirrer and thermometer was charged with 18.3 g of fluorine-containing norbornene derivative (M2-1) having -OH group: 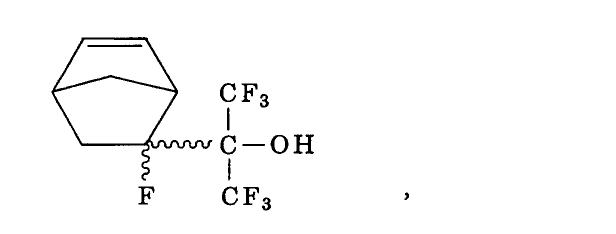 14.8 g of fluorine-containing norbornene derivative (M2-2) having -OCH₂OC₂H₅ group: 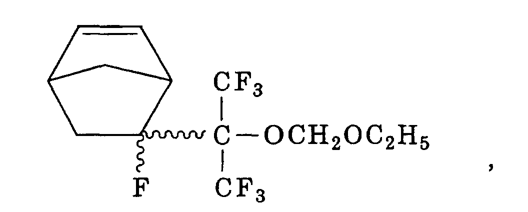 250 ml of HCFC-141b and 6.6 g of bis(4-t-butylcyclohexyl)peroxydicarbonate (TCP), and the inside of a system was sufficiently replaced with nitrogen gas. Then 52.0 g of TFE was introduced through the valve, followed by stirring at 40°C for 12 hours for reaction.

After releasing the un-reacted monomer, the polymerization solution was removed, followed by concentrating and re-precipitating with hexane to separate a copolymer. Until a constant weight was reached, vacuum drying was carried out to obtain 6.9 g of a copolymer.

As a result of ¹H-NMR and ¹⁹F-NMR analyses, the copolymer was a copolymer of TFE/fluorine-containing norbornene derivative (M2-1) having -OH group/ fluorine-containing norbornene derivative (M2-2) having -OCH₂OC₂H₅ group in a percent by mole ratio of 50/ 19/31.

According to GPC analysis, a number average molecular weight thereof was 3,000.

### PREPARATION EXAMPLE 9

### (Synthesis of copolymer comprising TFE, fluorine-containing norbornene derivative having -OH group and fluorine-containing norbornene derivative having -OCH₂OC₂H₅ group)

Polymerization reaction and separation and refining of a polymer were carried out in the same manner as in preparation Example 8 except that 24.5 g of the fluorine-containing norbornene derivative (M2-1) having -OH group, 7.4 g of the fluorine-containing norbornene derivative (M2-2) having -OCH₂OC₂H₅ group, 52.5 g of TFE and 6.5 g of TCP were used. Thus 7.2 g of a copolymer was obtained.

As a result of ¹H-NMR and ¹⁹F-NMR analyses, the copolymer was a copolymer of TFE/fluorine-containing norbornene derivative (M2-1) having -OH group/fluorine-containing norbornene derivative (M2-2) having -OCH₂OC₂H₅ group in a percent by mole ratio of 50/40/10.

According to GPC analysis, a number average molecular weight thereof was 3,200.

### PRREPARATION EXAMPLE 10

### (Synthesis of copolymer comprising TFE, fluorine-containing norbornene derivative having -OH group and fluorine-containing norbornene derivative having -OCH₂OC₂H₅ group)

Polymerization reaction and separation and refining of a polymer were carried out in the same manner as in Preparation Example 8 except that 27.5 g of the fluorine-containing norbornene derivative (M2-1) having -OH group, 3.7 g of the fluorine-containing norbornene derivative (M2-2) having -OCH₂OC₂H₅ group, 52.0 g of TFE and 6.5 g of TCP were used. Thus 7.6 g of a copolymer was obtained.

As a result of ¹H-NMR and ¹⁹F-NMR analyses, the copolymer was a copolymer of TFE/fluorine-containing norbornene derivative (M2-1) having -OH group/fluorine-containing norbornene derivative (M2-2) having -OCH₂OC₂H₅ group in a percent by mole ratio of 50/46/4.

According to GPC analysis, a number average molecular weight thereof was 3,500.

### PREPARATION EXAMPLE 11

### (Synthesis of copolymer comprising TFE, fluorine-containing norbornene derivative having -OH group and fluorine-containing norbornene derivative having -COOC(CH₃)₃ group)

A 500 ml autoclave equipped with a valve, pressure gauge, stirrer and thermometer was charged with 24.5 g of the fluorine-containing norbornene derivative (M2-1) having -OH group, 4.7 g of the fluorine-containing norbornene derivative (N-1) having -COOC(CH₃)₃ group: 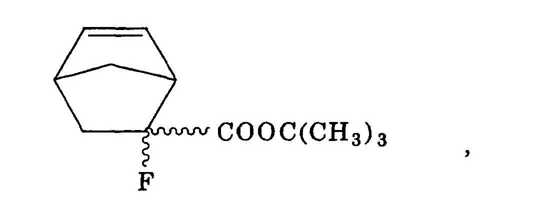 250 ml of HCFC-141b and 6.5 g of bis(4-t-butylcyclohexyl)peroxydicarbonate (TCP), and the inside of a system was sufficiently replaced with nitrogen gas. Then 52.0 g of TFE was introduced through the valve, followed by stirring at 40°C for 12 hours for reaction.

After releasing the un-reacted monomer, the polymerization solution was removed, followed by concentrating and re-precipitating with hexane to separate a copolymer. Until a constant weight was reached, vacuum drying was carried out to obtain 6.9 g of a copolymer.

As a result of ¹H-NMR and ¹⁹F-NMR analyses, the copolymer was a copolymer of TFE/fluorine-containing norbornene derivative (M2-1) having -OH group/fluorine-containing norbornene derivative (N-1) having -COOC(CH₃)₃ group in a percent by mole ratio of 50/40/ 10.

According to GPC analysis, a number average molecular weight thereof was 3,800.

### PREPARATION EXAMPLE 12

### (Synthesis of copolymer comprising TFE, fluorine-containing norbornene derivative having -OH group and fluorine-containing norbornene derivative having -COOC(CH₃)₃ group)

Polymerization reaction and separation and refining of a polymer were carried out in the same manner as in Preparation Example 11 except that 27.5 g of the fluorine-containing norbornene derivative (M2-1) having -OH group, 2.3 g of the fluorine-containing norbornene derivative (N-1) having -COOC(CH₃)₃ group, 52.0 g of TFE and 6.5 g of TCP were used. Thereby 7.3 g of a copolymer was obtained.

As a result of ¹H-NMR and ¹⁹F-NMR analyses, the copolymer was a copolymer of TFE/fluorine-containing norbornene derivative (M2-1) having -OH group/fluorine-containing norbornene derivative (N-1) having -COOC(CH₃)₃ group in a percent by mole ratio of 50/47/3.

According to GPC analysis, a number average molecular weight thereof was 4,000.

### PREPARATION EXAMPLE 13

### (Synthesis of copolymer comprising TFE and fluorine-containing norbornene having OH group)

Polymerization reaction and separation and refining of a polymer were carried out in the same manner as in Preparation Example 6 except that 32.5 g of a fluorine-containing norbornene (N-2) having OH group: 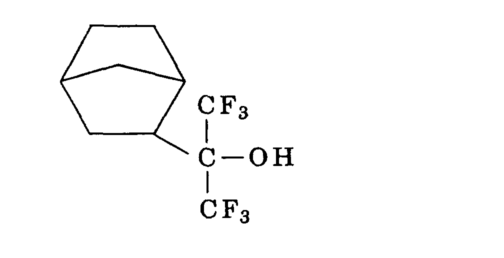 was used instead of the fluorine-containing norbornene (M2-1) having OH group. Thereby 4.5 g of a copolymer was obtained.

As a result of ¹H-NMR and ¹⁹F-NMR analyses, the copolymer was a copolymer of TFE/norbornene (N-2) having -OH group in a percent by mole ratio of 50/50.

According to GPC analysis, a number average molecular weight thereof was 3,800.

### EXAMPLE 5 and COMPARATIVE EXAMPLE 1

A vacuum ultraviolet absorption spectrum of the fluorine-containing copolymers obtained in Preparation Examples 6 and 8 to 12 (Example 5) and Preparation Example 13 (Comparative Example 1) was measured. An absorption coefficient per 1 µm at 157 nm of the fluorine-containing copolymers obtained in each Preparation Example is shown in Table 3.

**TABLE 3**

| | Fluorine-containing polymer | Absorption coefficient (µm⁻¹) |
|---|---|---|
| Ex. 5 | Prep. Ex. 6 | 0.93 |
| | Prep. Ex. 8 | 1.10 |
| | Prep. Ex. 9 | 0.76 |
| | Prep. Ex. 10 | 0.90 |
| | Prep. Ex. 11 | 1.90 |
| | Prep. Ex. 12 | 1.47 |
| Com. Ex. 1 | Prep. Ex. 13 | 1.50 |

### EXAMPLE 6

### (Evaluation of dry etching resistivity)

Dry etching resistivity was evaluated in the same manner as in Example 2 except that the fluorine-containing copolymers obtained in Preparation Examples 6 and 8 to 12 were used.

A coating thickness of the fluorine-containing copolymer film after the etching was measured with an optical film thickness meter (Lambda Ace available from Dai-Nippon Screen Seizo Kabushiki Kaisha), and an etching rate was calculated from the film thickness before the etching. The results are shown in Table 4.

An etching rate of ArF resist (AX-431 available from Sumitomo Chemical Industries, Ltd.) was measured for comparison under the same etching conditions. The etching rate (RIE rate) of the fluorine-containing copolymers of Preparation Examples 6 and 8 to 12 was calculated provided that the etching rate of ArF resist was 1. The results are shown in Table 4.

**TABLE 4**

| Fluorine-containing polymer | Etching rate (nm/min) | RIE rate |
|---|---|---|
| Prep. Ex. 6 | 109.25 | 1.15 |
| Prep. Ex. 8 | 106.4 | 1.12 |
| Prep. Ex. 9 | 108.3 | 1.14 |
| Prep. Ex. 10 | 104.5 | 1.10 |
| Prep. Ex. 11 | 96.9 | 1.02 |
| Prep. Ex. 12 | 100.7 | 1.06 |
| ArF resist | 95.0 | 1 |

### EXAMPLE 7 and COMPARATIVE EXAMPLE 2

### (Evaluation of solubility in developing solution)

A dissolving rate of the fluorine-containing polymers of Preparation Example 6 (Example 7) and Preparation Example 13 (Comparative Example 2) was measured by a quartz crystal microbalance method (QCM method) in the manner mentioned below.
(1) Production of sample: A 80 nm thick anti-reflection film (AR19 available from Shipley Co.) was formed on a 1 inch diameter quartz crystal microbalance plate coated with gold, and thereon was applied a solution prepared by dissolving the fluorine-containing polymer of Preparation Example 6 (or Preparation Example 13) in PGMEA, thus forming an about 100 nm coating film.
(2) Measurement of dissolving rate: A coating thickness is converted and calculated from frequency of quartz crystal microbalance. The above-mentioned quartz crystal microbalance plate coated with fluorine-containing polymer was dipped in an aqueous solution of 2.38 % by weight of tetramethylammonium hydroxide (TMAH). After the dipping, a change in a coating thickness was measured according to a change in a frequency per unit dipping time and thus a dissolving rate (nm/ sec) per unit time was calculated. The results are shown in Table 5.

**TABLE 5**

| | Fluorine-containing polymer | Dissolving rate (nm/ sec) |
|---|---|---|
| Ex. 7 | Prep. Ex. 6 | 187.5 |
| Com. Ex. 2 | Prep. Ex. 13 | 5.89 |

### EXAMPLE 8

Triphenylsulfonium·perfluorobutylsulfonate was added as a photoacid generator in an amount of 5 parts by weight to 100 parts by weight of the fluorine-containing copolymer prepared in Preparation Example 9, followed by dissolving in PGMEA to obtain a photosensitive composition. The obtained solution of photosensitive composition was applied on a silicon wafer coated with a 80 nm thick anti-reflection film (AR19 available from Shipley Co.) by using a spin coater and was dried at 110°C for 90 seconds to form a 150 nm thick resist film

This resist film was subjected to frame exposure on a spot of 1 cm × 1 cm square (1 cm²) by using F₂ excimer laser beam (wavelength 157 nm). After the exposing, heating was carried out on a heated plate at 110°C for 90 seconds, followed by developing with an aqueous solution of tetramethylammonium hydroxide (TMAH) having a concentration of 2.38 % by weight.

When the above-mentioned frame exposure, heating and developing were carried out in the same manner as above by changing exposure energy of F₂ excimer laser beam from 0.1 mJ/cm² to 100 mJ/cm², the spot of 1 cm² was completely dissolved at the exposure energy of not less than 2.5 mJ/cm², from which it was known that the fluorine-containing copolymer prepared in Preparation Example 9 had sensitivity which could make the copolymer function as a positive type resist.

Patterning was evaluated by using a reduction projection exposure system (157 nm micro stepper available from Ultra Tec Co.: Levenson Mask, NA/σ = 0.6/0.30 Conv.) using F₂ laser as light source. As a result, a 85 nm fine pattern of 1:1 L/S could be produced at an exposure energy of 9 mJ/cm². From this, it was known that the fluorine-containing resin prepared in Preparation Example 9 had resolution which could make the copolymer function as a positive type resist.

### EXAMPLE 9

A photosensitive composition was prepared and a resist film was formed in the same manner as in Example 8 except that the fluorine-containing copolymer obtained in Preparation Example 12 was used instead of the fluorine-containing copolymer obtained in Preparation Example 9. Then frame exposure using F₂ laser beam, heating and developing were carried out.

As a result, the spot of 1 cm² was completely dissolved at an exposure energy of not less than 2.5 mJ/cm², from which it was known that the fluorine-containing copolymer prepared in Preparation Example 12 had sensitivity which could make the copolymer function as a positive type resist.

Patterning was evaluated in the same manner as in Example 8 by using the reduction projection exposure system using F₂ laser as light source. As a result, a 80 nm fine pattern of 1:1 L/S could be produced at an exposure energy of 23 mJ/cm². From this, it was known that the fluorine-containing resin prepared in Preparation Example 12 had resolution which could make the copolymer function as a positive type resist.

### PREPARATION EXAMPLE 14

### (Synthesis of copolymer comprising TFE, fluorine-containing norbornene derivative having -OH group and fluorine-containing norbornene derivative having -O(C=O)OC(CH₃)₃ group)

A 500 ml autoclave equipped with a valve, pressure gauge, stirrer and thermometer was charged with 21.5 g of the fluorine-containing norbornene derivative (M2-1) having -OH group: 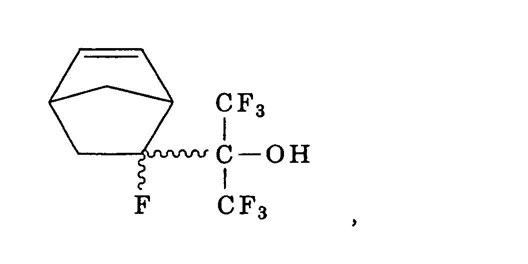 12.4 g of fluorine-containing norbornene derivative (M2-3) having -O(C=O)OC(CH₃)₃ group: 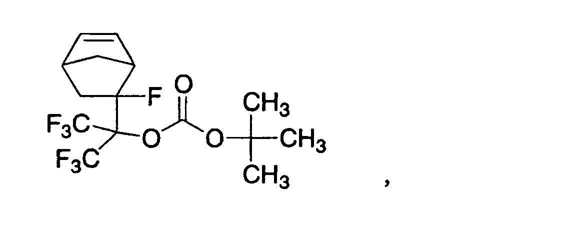 250 ml of HCFC-141b and 6.5 g of bis(4-t-butylcyclohexyl)peroxydicarbonate (TCP), and the inside of a system was sufficiently replaced with nitrogen gas. Then 52.0 g of TFE was introduced through the valve, followed by stirring at 40°C for 6 hours for reaction.

After releasing the un-reacted monomer, the polymerization solution was removed, followed by concentrating and re-precipitating with hexane to separate a copolymer. Until a constant weight was reached, vacuum drying was carried out to obtain 9.2 g of a copolymer.

As a result of ¹H-NMR and ¹⁹F-NMR analyses, the copolymer was a copolymer of TFE/fluorine-containing norbornene derivative (M2-1) having -OH group/fluorine-containing norbornene derivative (M2-3) having -O(C=O)OC(CH₃)₃ group in a percent by mole ratio of 50/39/11.

According to GPC analysis, a number average molecular weight thereof was 2,900.

### PREPARATION EXAMPLE 15

### (Synthesis of copolymer comprising TFE, fluorine-containing norbornene derivative having -OH group and fluorine-containing norbornene derivative having -O(C=O)OC(CH₃)₃ group)

Polymerization reaction and separation and refining of a polymer were carried out in the same manner as in Preparation Example 14 except that 27.5 g of the fluorine-containing norbornene derivative (M2-1) having -OH group, 4.2 g of the fluorine-containing norbornene derivative (M2-3) having -O(C=O)OC(CH₃)₃ group, 52.5 g of TFE and 6.5 g of TCP were used. Thereby 6.2 g of a copolymer was obtained.

As a result of ¹H-NMR and ¹⁹F-NMR analyses, the copolymer was a copolymer of TFE/fluorine-containing norbornene derivative (M2-1) having -OH group/fluorine-containing norbornene derivative (M2-3) having -O(C=O)OC(CH₃)₃ group in a percent by mole ratio of 50/46/4.

According to GPC analysis, a number average molecular weight thereof was 2,700.

### PREPARATION EXAMPLE 16

### (Synthesis of copolymer comprising TFE, fluorine-containing norbornene derivative having -OH group and fluorine-containing norbornene derivative having -COOC(CH₃)₃ group)

A 500 ml autoclave equipped with a valve, pressure gauge, stirrer and thermometer was charged with 15.3 g of the fluorine-containing norbornene derivative (M2-1) having -OH group: 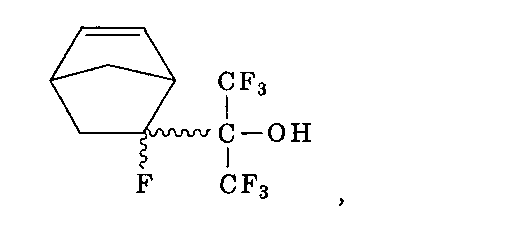 17.3 g of the fluorine-containing norbornene derivative (N-3) having -COOC(CH₃)₃ group: 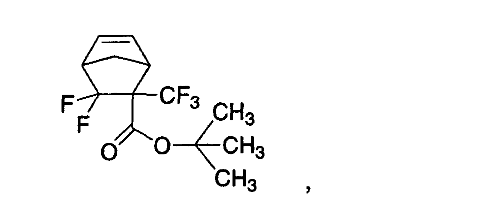 250 ml of HCFC-141b and 6.6 g of bis(4-t-butylcyclohexyl)peroxydicarbonate (TCP), and the inside of a system was sufficiently replaced with nitrogen gas. Then 52.0 g of TFE was introduced through the valve, followed by stirring at 40°C for 12 hours for reaction.

After releasing the un-reacted monomer, the polymerization solution was removed, followed by concentrating and re-precipitating with hexane to separate a copolymer. Until a constant weight was reached, vacuum drying was carried out to obtain 4.8 g of a copolymer.

As a result of ¹H-NMR and ¹⁹F-NMR analyses, the copolymer was a copolymer of TFE/fluorine-containing norbornene derivative (M2-1) having -OH group/fluorine-containing norbornene derivative (N-3) having -COOC(CH₃)₃ group in a percent by mole ratio of 50/36/ 14.

According to GPC analysis, a number average molecular weight thereof was 2,600.

### PREPARATION EXAMPLE 17

### (Synthesis of copolymer comprising TFE, fluorine-containing norbornene derivative having -OH group and fluorine-containing norbornene derivative having -COOC(CH₃)₃ group)

Polymerization reaction and separation and refining of a polymer were carried out in the same manner as in Preparation Example 16 except that 26.0 g of the fluorine-containing norbornene derivative (M2-1) having -OH group, 5.2 g of the fluorine-containing norbornene derivative (N-3) having -COOC(CH₃)₃ group, 52.5 g of TFE and 6.5 g of TCP were used. Thereby 5.2 g of a copolymer was obtained.

As a result of ¹H-NMR and ¹⁹F-NMR analyses, the copolymer was a copolymer of TFE/fluorine-containing norbornene derivative (M2-1) having -OH group/fluorine-containing norbornene derivative (N-3) having -COOC(CH₃)₃ group in a percent by mole ratio of 50/46/4.

According to GPC analysis, a number average molecular weight thereof was 2,600.

### PREPARATION EXAMPLE 18

### (Synthesis of copolymer comprising TFE, fluorine-containing norbornene derivative having -OCH₂OC₂H₅ group and fluorine-containing norbornene derivative having -COOH group)

A 500 ml autoclave equipped with a valve, pressure gauge, stirrer and thermometer was charged with 29.6 g of the fluorine-containing norbornene derivative (M2-2) having -OCH₂OC₂H₅ group: 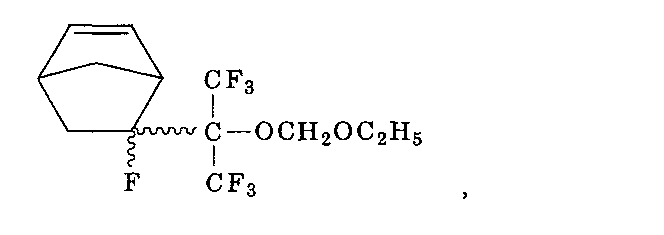 3.5 g of fluorine-containing norbornene derivative (N-4) having -COOH group: 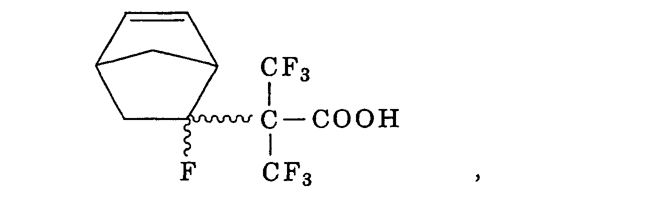 250 ml of HCFC-141b and 6.6 g of bis(4-t-butylcyclohexyl)peroxydicarbonate (TCP), and the inside of a system was sufficiently replaced with nitrogen gas. Then 52.0 g of TFE was introduced through the valve, followed by stirring at 40°C for 12 hours for reaction.

After releasing the un-reacted monomer, the polymerization solution was removed, followed by concentrating and re-precipitating with hexane to separate a copolymer. Until a constant weight was reached, vacuum drying was carried out to obtain 4.5 g of a copolymer.

As a result of ¹H-NMR and ¹⁹F-NMR analyses, the copolymer was a copolymer of TFE/fluorine-containing norbornene derivative (M2-2) having -OCH₂OC₂H₅ group/fluorine-containing norbornene derivative (N-4) having -COOH group in a percent by mole ratio of 50/37/13.

According to GPC analysis, a number average molecular weight thereof was 3,000.

### PREPARATION EXAMPLE 19

### (Synthesis of copolymer comprising TFE, fluorine-containing norbornene derivative having -OCH₂OC₂H₅ group and fluorine-containing norbornene derivative having -COOH group)

Polymerization reaction and separation and refining of a polymer were carried out in the same manner as in Preparation Example 18 except that 33.3 g of the fluorine-containing norbornene derivative (M2-2) having -OCH₂OC₂H₅ group, 1.8 g of the fluorine-containing norbornene derivative (N-4) having -COOH group, 52.5 g of TFE and 6.5 g of TCP were used. Thereby 4.0 g of a copolymer was obtained.

As a result of ¹H-NMR and ¹⁹F-NMR analyses, the copolymer was a copolymer of TFE/fluorine-containing norbornene derivative (M2-2) having -OCH₂OC₂H₅ group/fluorine-containing norbornene derivative (N-4) having -COOH group in a percent by mole ratio of 50/42/8.

According to GPC analysis, a number average molecular weight thereof was 2,800.

### PREPARATION EXAMPLE 20

### (Synthesis of copolymer comprising TFE, fluorine-containing norbornene derivative having -OH group and fluorine-containing norbornene derivative having -OCH₂OC₂H₅ group)

A 500 ml autoclave equipped with a valve, pressure gauge, stirrer and thermometer was charged with 27.6 g of fluorine-containing norbornene derivative (M2-4) having -OH group: 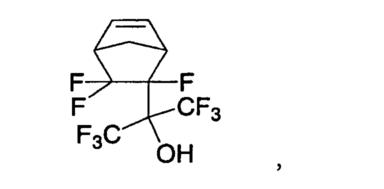 8.2 g of fluorine-containing norbornene derivative (M2-5) having -OCH₂OC₂H₅ group: 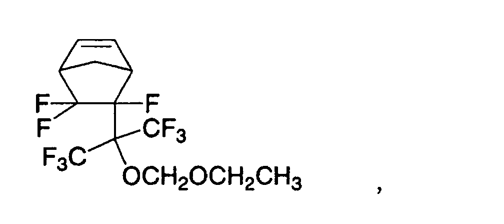 250 ml of HCFC-141 b and 6.6 g of bis(4-t-butylcyclohexyl)peroxydicarbonate (TCP), and the inside of a system was sufficiently replaced with nitrogen gas. Then 52.0 g of TFE was introduced through the valve, followed by stirring at 40°C for 12 hours for reaction.

After releasing the un-reacted monomer, the polymerization solution was removed, followed by concentrating and re-precipitating with hexane to separate a copolymer. Until a constant weight was reached, vacuum drying was carried out to obtain 4.1 g of a copolymer.

As a result of ¹H-NMR and ¹⁹F-NMR analyses, the copolymer was a copolymer of TFE/fluorine-containing norbornene derivative (M2-4) having -OH group/fluorine-containing norbornene derivative (M2-5) having -OCH₂OC₂H₅ group in a percent by mole ratio of 50/39/11.

According to GPC analysis, a number average molecular weight thereof was 2,900.

### PREPARATION EXAMPLE 21

### (Synthesis of copolymer comprising TFE, fluorine-containing norbornene derivative having -OH group and fluorine-containing norbornene derivative having -OCH₂OC₂H₅ group)

Polymerization reaction and separation and refining of a polymer were carried out in the same manner as in Preparation Example 20 except that 31.1 g of the fluorine-containing norbornene derivative (M2-4) having -OH group, 4.1 g of the fluorine-containing norbornene derivative (M2-5) having -OCH₂OC₂H₅ group, 52.5 of TFE and 6.5 of TCP were used. Thereby 4.5 g of a copolymer was obtained.

As a result of ¹H-NMR and ¹⁹F-NMR analyses, the copolymer was a copolymer of TFE/fluorine-containing norbornene derivative (M2-4) having -OH group/fluorine-containing norbornene derivative (M2-5) having -OCH₂OC₂H₅ group in a percent by mole ratio of 50/46/4.

According to GPC analysis, a number average molecular weight thereof was 2,700.

### PREPARATION EXAMPLE 22

### (Synthesis of copolymer comprising TFE, fluorine-containing norbornene derivative having -OH group and fluorine-containing norbornene derivative having -COOC(CH₃)₃ group)

A 500 ml autoclave equipped with a valve, pressure gauge, stirrer and thermometer was charged with 24.2 g of the fluorine-containing norbornene derivative (M2-4) having -OH group: 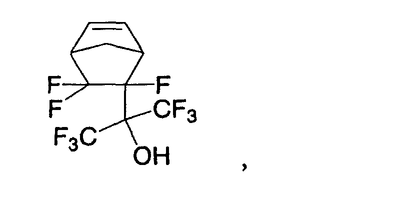 7.0 g of the fluorine-containing norbornene derivative (N-1) having -COOC(CH₃)₃ group: 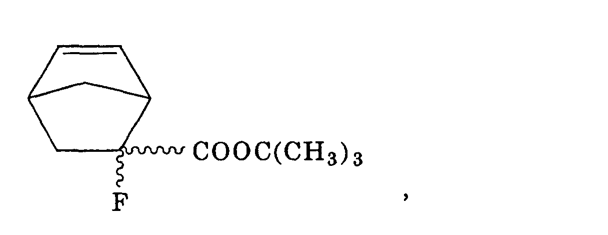 250 ml of HCFC-141b and 6.6 g of bis(4-t-butylcyclohexyl)peroxydicarbonate (TCP), and the inside of a system was sufficiently replaced with nitrogen gas. Then 52.0 g of TFE was introduced through the valve, followed by stirring at 40°C for 12 hours for reaction.

After releasing the un-reacted monomer, the polymerization solution was removed, followed by concentrating and re-precipitating with hexane to separate a copolymer. Until a constant weight was reached, vacuum drying was carried out to obtain 4.8 g of a copolymer.

As a result of ¹H-NMR and ¹⁹F-NMR analyses, the copolymer was a copolymer of TFE/fluorine-containing norbornene derivative (M2-4) having -OH group/fluorine-containing norbornene derivative (N-1) having -COOC(CH₃)₃ group in a percent by mole ratio of 50/25/25.

According to GPC analysis, a number average molecular weight thereof was 3,200.

### PREPARATION EXAMPLE 23

### (Synthesis of copolymer comprising TFE, fluorine-containing norbornene derivative having -OH group and fluorine-containing norbornene derivative having -COOC(CH₃)₃ group)

Polymerization reaction and separation and refining of a polymer were carried out in the same manner as in Preparation Example 22 except that 31.0 g of the fluorine-containing norbornene derivative (M2-4) having -OH group, 2.3 g of the fluorine-containing norbornene derivative (N-1) having -COOC(CH₃)₃ group, 52.5 of TFE and 6.5 of TCP were used. Thereby 5.0 g of a copolymer was obtained.

As a result of ¹H-NMR and ¹⁹F-NMR analyses, the copolymer was a copolymer of TFE/fluorine-containing norbornene derivative (M2-4) having -OH group/fluorine-containing norbornene derivative (N-1) having -COOC(CH₃)₃ group in a percent by mole ratio of 50/39/11.

According to GPC analysis, a number average molecular weight thereof was 2,900.

### EXAMPLE 10

A vacuum ultraviolet absorption spectrum of the fluorine-containing copolymers obtained in Preparation Examples 14 to 23 was measured. An absorption coefficient per 1 µm at 157 nm of the fluorine-containing copolymers obtained in each Preparation Example is shown in Table 6.

**TABLE 6**

| Fluorine-containing polymer | Absorption coefficient (1 µm⁻¹) |
|---|---|
| Prep. Ex. 14 | 1.67 |
| Prep. Ex. 15 | 1.65 |
| Prep. Ex. 16 | 1.7 |
| Prep. Ex. 17 | 1.5 |
| Prep. Ex. 18 | 2.3 |
| Prep. Ex. 19 | 2.0 |
| Prep. Ex. 20 | 0.6 |
| Prep. Ex. 21 | 0.5 |
| Prep. Ex. 22 | 1.9 |
| Prep. Ex. 23 | 1.2 |

### EXAMPLE 11

Triphenylsulfonium·perfluorobutylsulfoniate was added as a photoacid generator in an amount of 5 parts by weight to 100 parts by weight of the fluorine-containing copolymer prepared in Preparation Example 14, followed by dissolving in PGMEA to obtain a photosensitive composition. The obtained solution of photosensitive composition was applied on a silicon wafer coated with a 80 nm thick anti-reflection film (AR19 available from Shipley Co.) by using a spin coater and was dried at 110°C for 90 seconds to form a 150 nm thick resist film

This resist film was subjected to frame exposure on a spot of 1 cm × 1 cm square (1 cm²) by using F₂ excimer laser beam (wavelength 157 nm). After the exposing, heating was carried out on a heated plate at 110°C for 90 seconds, followed by developing with an aqueous solution of tetramethylammonium hydroxide (TMAH) having a concentration of 2.38 % by weight.

When the above-mentioned frame exposure, heating and developing were carried out in the same manner as above by changing exposure energy of F₂ excimer laser beam from 0.1 mJ/cm² to 100 mJ/cm², the spot of 1 cm² was completely dissolved at the exposure energy of not less than 6.3 mJ/cm², from which it was known that the fluorine-containing copolymer prepared in Preparation Example 14 had sensitivity which could make the copolymer function as a positive type resist.

Patterning was evaluated by using a reduction projection exposure system (157 nm micro stepper available from Ultra Tec Co.: Levenson Mask, NA/σ = 0.6/0.30 Conv.) using F₂ laser as light source. As a result, a 85 nm fine pattern of 1:1 L/S could be produced at an exposure energy of 26 mJ/cm². From this, it was known that the fluorine-containing resin prepared in Preparation Example 14 had resolution which could make the copolymer function as a positive type resist.

### EXAMPLE 12

A photosensitive composition was prepared and a resist film was formed in the same manner as in Example 11 except that the fluorine-containing copolymer obtained in Preparation Example 16 was used instead of the fluorine-containing copolymer obtained in Preparation Example 14. Then frame exposure using F₂ laser beam, heating and developing were carried out.

As a result, the spot of 1 cm² was completely dissolved at the exposure energy of not less than 10 mJ/cm², from which it was known that the fluorine-containing copolymer prepared in Preparation Example 16 had sensitivity which could make the copolymer function as a positive type resist.

Patterning was evaluated in the same manner as in Example 11 by using the reduction projection exposure system using F₂ laser as light source. As a result, a 140 nm fine pattern of 1:1 L/S could be produced at an exposure energy of 56 mJ/cm². From this, it was known that the fluorine-containing resin prepared in Preparation Example 16 had resolution which could make the copolymer function as a positive type resist.

### EXAMPLE 13

A photosensitive composition was prepared and a resist film was formed in the same manner as in Example 11 except that the fluorine-containing copolymer obtained in Preparation Example 19 was used instead of the fluorine-containing copolymer obtained in Preparation Example 14. Then frame exposure using F₂ laser beam, heating and developing were carried out.

As a result, the spot of 1 cm² was completely dissolved at the exposure energy of not less than 2.5 mJ/cm², from which it was known that the fluorine-containing copolymer prepared in Preparation Example 19 had sensitivity which could make the copolymer function as a positive type resist.

Patterning was evaluated in the same manner as in Example 11 by using the reduction projection exposure system using F₂ laser as light source. As a result, a 80 nm fine pattern of 1:1 L/S could be produced at an exposure energy of 13 mJ/cm². From this, it was known that the fluorine-containing resin prepared in Preparation Example 19 had resolution which could make the copolymer function as a positive type resist.

### EXAMPLE 14

A photosensitive composition was prepared and a resist film was formed in the same manner as in Example 11 except that the fluorine-containing copolymer obtained in Preparation Example 20 was used instead of the fluorine-containing copolymer obtained in Preparation Example 14. Then frame exposure using F₂ laser beam, heating and developing were carried out.

As a result, the spot of 1 cm² was completely dissolved at the exposure energy of not less than 3.5 mJ/cm², from which it was known that the fluorine-containing copolymer prepared in Preparation Example 20 had sensitivity which could make the copolymer function as a positive type resist.

Patterning was evaluated in the same manner as in Example 11 by using the reduction projection exposure system using F₂ laser as light source. As a result, a 80 nm fine pattern of 1:1 L/S could be produced at an exposure energy of 18 mJ/cm². From this, it was known that the fluorine-containing resin prepared in Preparation Example 20 had resolution which could make the copolymer function as a positive type resist.

### EXAMPLE 15

A photosensitive composition was prepared and a resist film was formed in the same manner as in Example 11 except that the fluorine-containing copolymer obtained in Preparation Example 23 was used instead of the fluorine-containing copolymer obtained in Preparation Example 14. Then frame exposure using F₂ laser beam, heating and developing were carried out.

As a result, the spot of 1 cm² was completely dissolved at the exposure energy of not less than 3.8 mJ/cm², from which it was known that the fluorine-containing copolymer prepared in Preparation Example 23 had sensitivity which could make the copolymer function as a positive type resist.

Patterning was evaluated in the same manner as in Example 11 by using the reduction projection exposure system using F₂ laser as light source. As a result, a 80 nm fine pattern of 1:1 L/S could be produced at an exposure energy of 21 mJ/cm². From this, it was known that the fluorine-containing resin prepared in Preparation Example 23 had resolution which could make the copolymer function as a positive type resist.

### INDUSTRIAL APPLICABILITY

According to the present invention, a very accurate fine resist pattern of a photosensitive layer being excellent in transparency and dry etching resistivity can be formed on a substrate or on a given layer on the substrate.

## Claims

1. A method of forming a fine resist pattern comprising, a step for forming a photosensitive layer on a substrate or a given layer on a substrate by using a photosensitive composition comprising at least a compound generating an acid by irradiation of light and a fluorine-containing polymer, a step for exposing by selectively irradiating a given area of said photosensitive layer with energy ray, a step for heat-treating said exposed photosensitive layer and a step for forming a fine pattern by developing said heat-treated photosensitive layer to selectively remove an exposed portion or an un-exposed portion of said photosensitive layer, said fluorine-containing polymer is a fluorine-containing polymer which has a number average molecular weight of from 500 to 1,000,000 and is represented by the formula (1):
-(M1)-(M2)-(A1)- (1)
wherein the structural unit M1 is a structural unit derived from an ethylenic monomer having 2 or 3 carbon atoms and at least one fluorine atom;
the structural unit M2 is a structural unit derived from at least one selected from norbornene derivatives having a fluorine-containing alcohol structure represented by the formula (2): 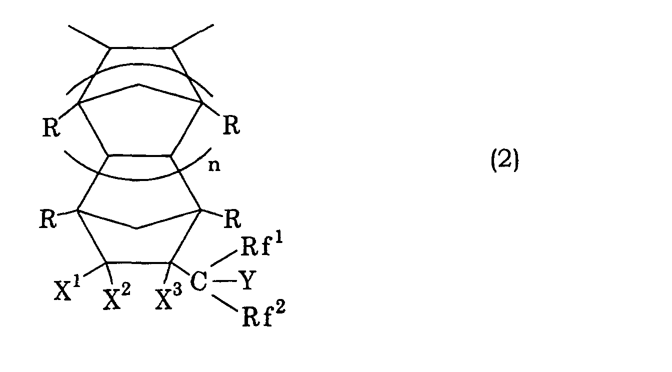 wherein Rf¹ and Rf² are the same or different and each is a fluorine-containing alkyl group having 1 to 10 carbon atoms or a fluorine-containing alkyl group which has 1 to 10 carbon atoms and ether bond; Y is OH group or a group dissociated due to action of an acid and converted to OH group; X¹, X² and X³ are the same or different and each is H, F, Cl, an alkyl group having 1 to 10 carbon atoms or a fluorine-containing alkyl group which has 1 to 10 carbon atoms and may have ether bond; R are the same or different and each is H or an alkyl group having 1 to 10 carbon atoms; n is 0 or an integer of from 1 to 5; at least one of X¹, X² and X³ is F or a fluorine-containing alkyl group which has 1 to 10 carbon atoms and may have ether bond;
the structural unit A1 is a structural unit derived from monomer copolymerizable with the structural units M1 and M2,
provided that M1 + M2 is 100 % by mole, a percent by mole ratio of M1/M2 is 99/1 to 30/70, and
the structural units M1, M2 and A1 are contained in amounts of from 1 to 99 % by mole, from 1 to 99 % by mole and from 0 to 98 % by mole, respectively.

2. The method of forming a fine resist pattern of Claim 1, wherein the fluorine-containing polymer is a fluorine-containing polymer which is represented by the formula (1)-1:
-(M1)-(M2-1)-(M2-2)-(A1)- (1)-1
wherein the structural unit M 1 is as defined in the formula (1);
the structural unit M2-1 is a structural unit derived from at least one selected from norbornene derivatives having a fluorine-containing alcohol structure represented by the formula (2)-1: 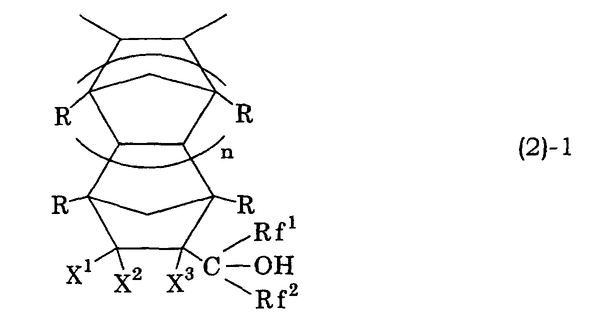 wherein Rf¹, Rf², R, X¹, X², X³ and n are as defined in the formula (2);
the structural unit M2-2 is a structural unit derived from at least one selected from norbornene derivatives represented by the formula (2)-2: 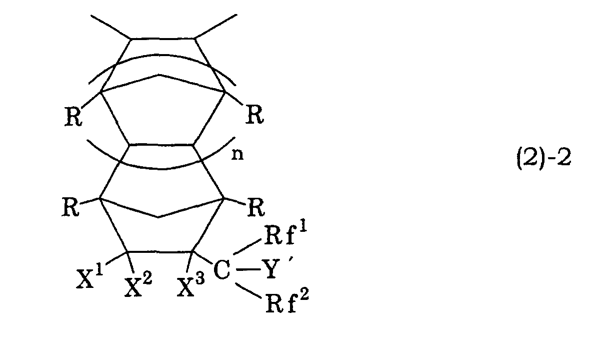 wherein Y' is a group dissociated due to action of an acid and converted to OH group, Rf¹, Rf², R, X¹, X², X³ and n are as defined in the formula (2);
the structural unit A1 is a structural unit derived from monomer copolymerizable with the structural units M1, M2-1 and M2-2,
provided that M1 + (M2-1) + (M2-2) is 100 % by mole, a percent by mole ratio of M1/((M2-1) + (M2-2)) is 70/30 to 30/70, and provided that (M2-1) + (M2-2) is 100 % by mole, a percent by mole ratio of (M2-1)/(M2-2) is 95/5 to 40/60,
the structural units M1, M2-1, M2-2 and A1 are contained in amounts of from 1 to 98 % by mole, from 1 to 98 % by mole, from 1 to 98 % by mole and from 0 to 97 % by mole, respectively.

3. The method of forming a fine resist pattern of Claim 1, wherein the fluorine-containing polymer is a fluorine-containing polymer which is represented by the formula (1)-2:
-(M1)-(M2)-(A4)-(A1)- (1)-2
wherein the structural units M1 and M2 are as defined in the formula (1);
the structural unit A4 is a structural unit comprising a cyclic aliphatic unsaturated hydrocarbon which is copolymerizable with a fluorine-containing ethylenic monomer constituting the structural unit M1 and further has COOH group or an acid-labile functional group Y² which can be converted to carboxyl by an acid,
the structural unit A1 is a structural unit derived from monomer copolymerizable with the structural units M1, M2 and A4,
provided that M1 + M2 + A4 is 100 % by mole, a percent by mole ratio of M1/(M2 + A4) is 70/30 to 30/70, and
the structural unit M1, M2, A4 and A1 are contained in amounts of from 1 to 98 % by mole, from 1 to 98 % by mole, from 1 to 98 % by mole and from 0 to 97 % by mole, respectively.

4. The method of forming a fine resist pattern of Claim 3, wherein in the fluorine-containing polymer of the formula (1)-2, the structural unit A4 is a structural unit derived from a norbornene derivative having COOH group or an acid-labile functional group Y² which can be converted to carboxyl by an acid.

5. The method of forming a fine resist pattern of Claim 4, wherein the norbornene derivative having COOH group or an acid-labile functional group Y² which can be converted to carboxyl by an acid is one represented by the formula (3): 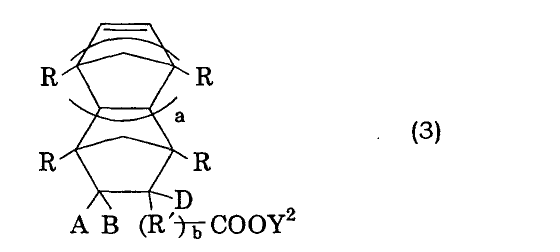 wherein A, B and D are H, F, alkyl groups having 1 to 10 carbon atoms or fluorine-containing alkyl groups having 1 to 10 carbon atoms; R are the same or different and each is H or an alkyl group having 1 to 10 carbon atoms; R' is a divalent hydrocarbon group having 1 to 20 carbon atoms, a fluorine-containing alkylene group having 1 to 20 carbon atoms or a fluorine-containing alkylene group having 2 to 100 carbon atoms and ether bond; a is 0 or an integer of from 1 to 5; b is 0 or 1; COOY² is COOH group or an acid-labile functional group which can be converted to carboxyl by an acid; provided that b is 0 or R' does not have fluorine atom, any one of A, B and D is fluorine atom or a fluorine-containing alkyl group.

6. The method of forming a fine resist pattern of Claim 1, wherein the fluorine-containing polymer is a fluorine-containing polymer which is represented by the formula (1)-3:
-(M1)-(M2-1)-(A4-1)-(A1)- (1)-3
wherein the structural unit M1 and M2-1 are as defined in the formula (1)-1 of Claim 2;
the structural unit A4-1 is a structural unit derived from a norbornene derivative represented by the formula (3)-1: 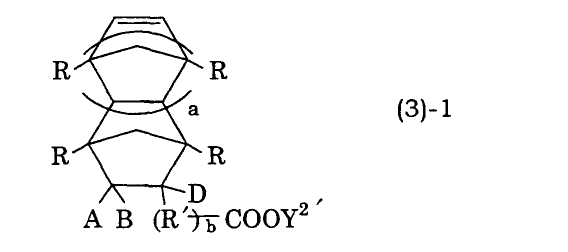 wherein COOY²' is an acid-labile functional group which can be converted to carboxyl by an acid; A, B, D, R, R', a and b are as defined in the formula (3),
the structural unit A1 is a structural unit derived from monomer copolymerizable with the structural units M1, (M2-1) and (A4-1),
provided that M1 + (M2-1) + (A4-1) is 100 % by mole, a percent by mole ratio of M1/((M2-1) + (A4-1)) is 70/30 to 30/70, and provided that (M2-1) + (A4-1) is 100 % by mole, a percent by mole ratio of (M2-1)/(A4-1) is 95/5 to 40/60, and
the structural unit M1, M2-1, A4-1 and A1 are contained in amounts of from 1 to 98 % by mole, from 1 to 98 % by mole, from 1 to 98 % by mole and from 0 to 97 % by mole, respectively.

7. The method of forming a fine resist pattern of any of Claims 1 to 6, wherein in said fluorine-containing polymers, the structural unit M1 is a structural unit obtained from at least one monomer selected from the group consisting of tetrafluoroethylene and chlorotrifluoroethylene.

8. The method of forming a fine resist pattern of any of Claims 1 to 7, wherein the structural units M2, M2-1 and M2-2 are structural units derived from the norbornene derivatives having a fluorine-containing alcohol structure of the formulae (2), (2)-1 and (2)-2, respectively in which X¹ and X² are H and X³ is F or CF₃.

9. The method of forming a fine resist pattern of any of Claims 1 to 7, wherein the structural units M2, M2-1 and M2-2 are structural units derived from the norbornene derivatives having a fluorine-containing alcohol structure of the formulae (2), (2)-1 and (2)-2, respectively in which X¹ and X² are F and X³ is F or CF₃.

10. The method of forming a fine resist pattern of any of Claims 1 to 9, wherein the structural units M2, M2-1 and M2-2 are structural units derived from the norbornene derivatives having a fluorine-containing alcohol structure of the formulae (2), (2)-1 and (2)-2, respectively in which Rf¹ and Rf² are CF₃.

11. The method of forming a fine resist pattern of any of Claims 1 to 5 and 7 to 10, wherein the group dissociated due to action of an acid and converted to OH group is one selected from the group consisting of: 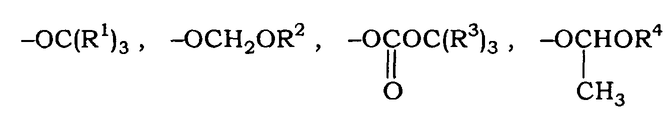 or 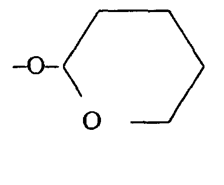 wherein R¹, R², R³ and R⁴ are alkyl groups having 1 to 5 carbon atoms.

12. The method of forming a fine resist pattern of any of Claims 1 to 11, wherein F₂ excimer laser beam is used as said energy ray.

13. The method of forming a fine resist pattern of any of Claims 1 to 11, wherein ArF excimer laser beam is used as said energy ray.

14. The method of forming a fine resist pattern of any of Claims 1 to 11, wherein KrF excimer laser beam is used as said energy ray.

15. The method of forming a fine resist pattern of any of Claims 1 to 11, wherein high energy electron beam is used as said energy ray.

16. The method of forming a fine resist pattern of any of Claims 1 to 11, wherein high energy ion beam is used as said energy ray.

17. The method of forming a fine resist pattern of any of Claims 1 to 11, wherein X-ray is used as said energy ray.

18. A method of forming a fine circuit pattern comprising, in order, a step for forming a fine resist pattern by the method of any of Claims 1 to 17 on a substrate or on a given layer on a substrate, and a step for forming an intended circuit pattern by etching said substrate or said given layer through the fine resist pattern.
